# EUROPEAN PATENT APPLICATION

(11) **EP 4 852 698 A1**
(43) Date of publication of application: **09.12.2026**
(21) Application number: 26168967.3
(22) Date of filing: 30.03.2026
(51) Int. Cl.: H10W 20/41, H10W 20/00, H10W 20/42, H10W 42/00

(54) **SEMICONDUCTOR DEVICES INCLUDING A DUMMY STRUCTURE AND SEMICONDUCTOR PACKAGES INCLUDING THE SAME**

(30) Priority: 04.06.2025 KR 20250072752
(71) Applicant: Samsung Electronics Co., Ltd., Suwon-si, Gyeonggi-do 16677 (KR)
(72) Inventor: PARK, Dongsik, 16677 Suwon-si (KR); CHOI, Kyoseon, 16677 Suwon-si (KR); BAE, Injae, 16677 Suwon-si (KR); KIM, Hyeontae, 16677 Suwon-si (KR); KWAK, Chaeseok, 16677 Suwon-si (KR); HAN, Minchul, 16677 Suwon-si (KR); LEE, Kyusun, 16677 Suwon-si (KR)
(74) Representative: Marks & Clerk LLP

(57) **Abstract**

A semiconductor device includes a substrate including a device region, a buffer region surrounding the device region, and an edge region surrounding the buffer region; upper connection patterns stacked in a vertical direction on the device region; an first pad disposed on the upper connection patterns and electrically connected to upper connection patterns; a second pad spaced apart from the first pad; guard-ring patterns stacked in the vertical direction on the buffer region to surround the device region; blocking patterns stacked in the vertical direction on the edge region; and an isolation trench penetrating at least a portion of guard-ring patterns on the buffer region.

## Description

### FIELD

Example embodiments of the present disclosure relate to a semiconductor device and a semiconductor package including the same.

### BACKGROUND

Demand for performance and stability of semiconductor devices has increased. Furthermore, performance and stability of semiconductor devices mounted on semiconductor packages have also been emphasized. Manufacturing a semiconductor device in response to the performance and stability trend may involve a variety of techniques. In particular, techniques for improving reliability of a semiconductor device may be important.

### SUMMARY

An example embodiment of the present disclosure is to provide a semiconductor device having improved reliability and performance, and a semiconductor package including the same.

According to an example embodiment of the present disclosure, a semiconductor device includes: a lower structure; and an upper structure on the lower structure, wherein the lower structure includes: a substrate including a device region, a buffer region surrounding the device region, and an edge region surrounding the buffer region; an interconnection structure including a plurality of interconnection pattern layers stacked in a vertical direction on the device region; a guard-ring structure including a plurality of guard-ring pattern layers stacked in the vertical direction on the buffer region to surround the device region; and a dummy structure including a plurality of dummy pattern layers stacked in the vertical direction on the edge region, a plurality of dummy via layers, and at least one dummy connection layer between the substrate and a lowest dummy pattern layer among the plurality of dummy pattern layers, wherein the upper structure includes: pad structures on the device region; and a passivation layer on the pad structures, wherein the pad structures include: an active pad structure disposed on the interconnection structure and electrically connected to the plurality of interconnection pattern layers; and a dummy pad structure including a first dummy pad portion spaced apart from the active pad structure and extending along the buffer region and the edge region from the first dummy pad portion, where an end of the dummy pad structure is disposed on the dummy structure, wherein the at least one dummy connection layer of the dummy structure extends in a first direction and has a repeating pattern, and wherein the passivation layer includes: a first portion including openings respectively exposing the active pad structure and the first dummy pad portion of the dummy pad structure on the device region, and the first portion extending from the device region to the buffer region and the edge region; and a second portion disposed on the buffer region, extending downwardly from the first portion, and penetrating at least a portion of the plurality of guard-ring pattern layers of the guard-ring structure..

According to an example embodiment of the present disclosure, a semiconductor device includes: a substrate including a device region, a buffer region surrounding the device region, and an edge region surrounding the buffer region; an interconnection structure including a plurality of interconnection pattern layers stacked in a vertical direction on the device region; a guard-ring structure including a plurality of guard-ring pattern layers stacked in the vertical direction on the buffer region to surround the device region; a dummy structure including a plurality of dummy pattern layers stacked in the vertical direction on the edge region, a plurality of dummy via layers, and a plurality of dummy connection layers between the substrate and a lowest dummy pattern layer of the plurality of dummy pattern layers; and an isolation structure penetrating at least a portion of the plurality of guard-ring pattern layers of the guard-ring structure on the buffer region, the isolation structure including a first side adjacent to the interconnection structure and a second side opposite the first side, wherein the guard-ring structure includes: a first portion disposed on the first side and having a first width; and a second portion disposed on the second side and having a second width different from the first width, and wherein the plurality of dummy connection layers of the dummy structure extends in a first direction and has a repeating pattern.

According to an example embodiment of the present disclosure, a semiconductor device includes: a substrate including a device region, a buffer region surrounding the device region, and an edge region surrounding the buffer region; an interconnection structure including a plurality of interconnection pattern layers stacked in a vertical direction on the device region; an active pad structure disposed on the interconnection structure and electrically connected to the plurality of interconnection pattern layers; a dummy pad structure spaced apart from the active pad structure; a guard-ring structure including a plurality of guard-ring pattern layers stacked in the vertical direction on the buffer region to surround the device region; a dummy structure including a plurality of dummy pattern layers stacked in the vertical direction on the edge region, a plurality of dummy via layers, and a plurality of dummy connection layers between the substrate and a lowest dummy pattern layer of the plurality of dummy pattern layers; and an isolation structure penetrating at least a portion of the plurality of guard-ring pattern layers of the guard-ring structure on the buffer region, wherein the dummy pad structure includes: a first dummy pad portion on the device region; and an extension portion extending from the first dummy pad portion to the buffer region, and wherein the isolation structure is in contact with one side of the extension portion of the dummy pad structure.

At least some of the above and other features of the invention are set out in the claims.

### BRIEF DESCRIPTION OF DRAWINGS

The above and other aspects, features, and advantages of the present disclosure will be more clearly understood from the following detailed description, taken in combination with the accompanying drawings, in which:
FIG. 1 is a plan diagram illustrating a semiconductor substrate including a semiconductor device according to an example embodiment of the present disclosure;
FIG. 2 is an enlarged diagram illustrating region 'A' illustrated in FIG. 1;
FIGS. 3A and 3B are vertical cross-sectional diagrams illustrating a semiconductor substrate in relation to a method of manufacturing a semiconductor device according to an example embodiment of the present disclosure;
FIG. 4A is a plan diagram illustrating a horizontal cross-section of dummy connection layers according to an example embodiment of the present disclosure;
FIG. 4B is a perspective diagram illustrating a three-dimensional shape of the dummy connection layers illustrated in FIG. 4A;
FIG. 5 is a perspective diagram illustrating a three-dimensional shape of dummy connection layers according to an example embodiment of the present disclosure;
FIG. 6 is a perspective diagram illustrating a three-dimensional shape of dummy connection layers according to an example embodiment of the present disclosure;
FIGS. 7A and 7B are vertical cross-sectional diagrams illustrating a semiconductor substrate in relation to a method of manufacturing a semiconductor device according to an example embodiment of the present disclosure;
FIGS. 8A and 8B are vertical cross-sectional diagrams illustrating a semiconductor substrate in relation to a method of manufacturing a semiconductor device according to an example embodiment of the present disclosure;
FIGS. 9A and 9B are vertical cross-sectional diagrams illustrating a semiconductor substrate in relation to a method of manufacturing a semiconductor device according to an example embodiment of the present disclosure;
FIGS. 10A and 10B are vertical cross-sectional diagrams illustrating a semiconductor substrate in relation to a method of manufacturing a semiconductor device according to an example embodiment of the present disclosure;
FIG. 11 is a plan diagram illustrating a semiconductor device according to an example embodiment of the present disclosure;
FIG. 12 is a perspective diagram illustrating a three-dimensional shape of dummy connection layers of a semiconductor device according to an example embodiment of the present disclosure;
FIG. 13 is a perspective diagram illustrating a three-dimensional shape of dummy connection layers of a semiconductor device according to an example embodiment of the present disclosure;
FIG. 14A is a perspective diagram illustrating a three-dimensional shape of dummy connection layers of a semiconductor device according to an example embodiment of the present disclosure;
FIG. 14B is a diagram illustrating a horizontal cross-section of the dummy connection layers in FIG. 14A;
FIG. 15 is a diagram illustrating a horizontal cross-section of dummy connection layers of a semiconductor device according to an example embodiment of the present disclosure;
FIG. 16 is a diagram illustrating a horizontal cross-section of dummy connection layers of a semiconductor device according to an example embodiment of the present disclosure;
FIG. 17 is a plan diagram illustrating a semiconductor device according to an example embodiment of the present disclosure;
FIG. 18 is a perspective diagram illustrating an arrangement of guard-ring pattern layers of a semiconductor device in a vertical direction according to an example embodiment of the present disclosure;
FIG. 19 is a perspective diagram illustrating an arrangement of guard-ring connection layers of a semiconductor device in a vertical direction according to an example embodiment of the present disclosure;
FIG. 20 is a vertical cross-sectional diagram illustrating a semiconductor device according to an example embodiment of the present disclosure;
FIG. 21 is an enlarged diagram illustrating region 'B' illustrated in FIG. 20;
FIG. 22 is a vertical cross-sectional diagram illustrating a semiconductor package including a semiconductor device according to an example embodiment of the present disclosure;
FIG. 23 is an enlarged diagram illustrating region 'C' illustrated in FIG. 22; and
FIG. 24 is a vertical cross-sectional diagram illustrating a semiconductor package including a semiconductor device according to an example embodiment of the present disclosure.

### DETAILED DESCRIPTION

Hereinafter, embodiments of the present disclosure will be described as follows with reference to the accompanying drawings.

Spatially relative terms, such as "beneath," "below," "lower," "above" "upper," "top," "bottom," and the like, may be used herein for ease of description to describe one element's or feature's relationship to another element(s) or feature(s) as illustrated in the figures. For example, the terms such as "upper," "upper portion," "upper surface," "lower," "lower portion," "lower surface," "side surface," "upper end," and "lower end" may be used with reference to the drawings.

Ordinal numbers such as "first," "second," "third," etc. may be used simply as labels of certain elements, steps, etc., to distinguish such elements, steps, etc. from one another. Terms that are not described using "first," "second," etc., in the specification, may still be referred to as "first" or "second" in a claim. In addition, a term that is referenced with a particular ordinal number (e.g., "first" in a particular claim) may be referenced elsewhere without an ordinal number or with a different ordinal number (e.g., "second" in the specification or another claim). For example, the terms such as "upper portion," "intermediate portion," and "lower portion" may alternatively be expressed as "first portion," "second portion," and "third portion," respectively.

Items described in the singular herein may be provided in plural, as can be seen, for example, in the drawings. Thus, the description of a single item that is provided in plural should be understood to be applicable to the remaining plurality of items unless the context indicates otherwise.

Throughout the specification, when a component is described as "including" a particular element or group of elements, it is to be understood that the component is formed of only the element or the group of elements, or the element or group of elements may be combined with additional elements to form the component, unless the context indicates otherwise. The term "consisting of," on the other hand, indicates that a component is formed only of the element(s) listed.

It will be understood that when an element is referred to as being "connected" or "coupled" to or "on" another element, it can be directly connected or coupled to or on the other element or intervening elements may be present. In contrast, when an element is referred to as being "directly connected" or "directly coupled" to another element, or as "contacting" or "in contact with" another element (or using any form of the word "contact"), there are no intervening elements present at the point of contact. As the state of contact is binary (either in contact or not in contact), it will be appreciated that "contact" has the same scope as any use of "direct contact."

Terms such as "same," "equal," "constant," "flat," etc. as used herein, are intended to encompass meanings that include typical variations resulting from conventional manufacturing processes and/or accommodate tolerances acceptable in the manufacturing process of the semiconductor device, unless the context or other statements indicate otherwise. For example, 'same' and 'equal' may encompass identicality or near identicality. The term "substantially" may be used herein to emphasize this meaning.

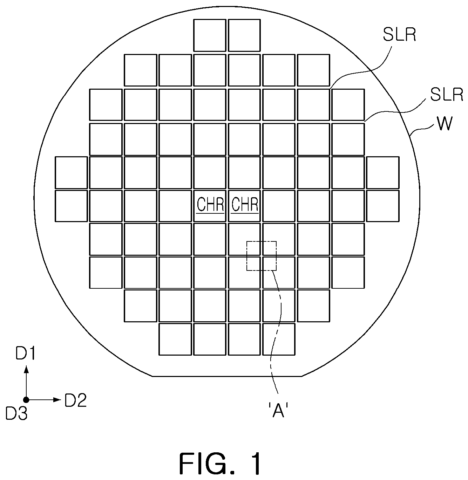

FIG. 1 is a plan diagram illustrating a semiconductor substrate (or wafer) including a plurality of semiconductor devices according to an example embodiment.

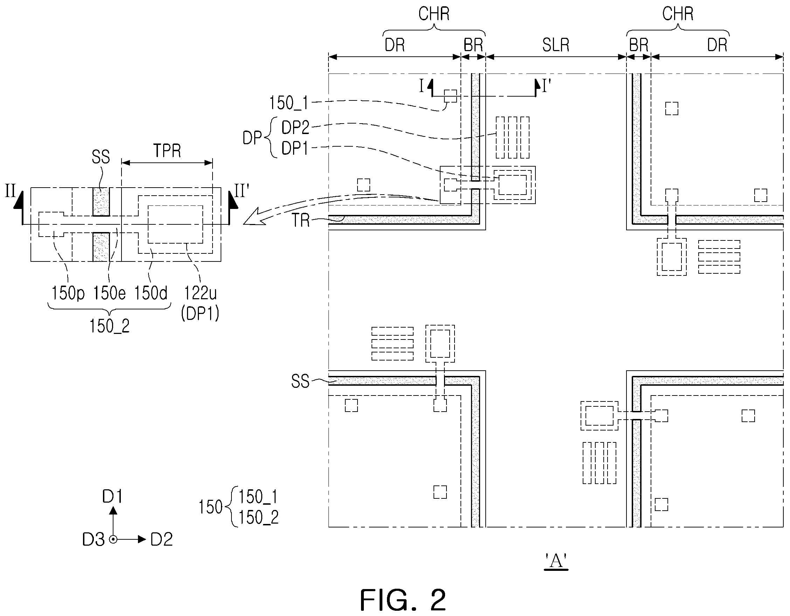

FIG. 2 is an enlarged diagram illustrating region 'A' illustrated in FIG. 1, illustrating a semiconductor substrate (or wafer) that may be subsequently subjected to a series of process steps (e.g., a dicing process along a scribe lane region SLR as described later) such that the semiconductor wafer may be divided into a plurality of chip regions (or chips) CHR.

Referring to FIGS. 1 and 2, a semiconductor wafer W may include chip regions CHR and the scribe lane region SLR between the chip regions CHR.

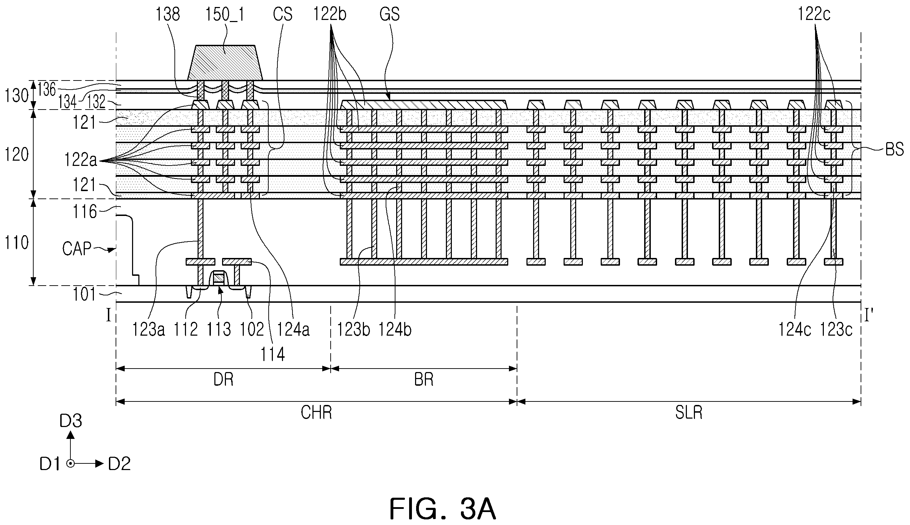

The chip regions CHR may include a device region DR in which integrated circuit elements (e.g., an integrated circuit including first individual devices (or transistors) 113 shown in FIG. 3A) are disposed, and a buffer region BR surrounding the device region DR in a plan view and including a guard ring (e.g., GS in FIG. 3A) disposed therein. For convenience of explanation, it is noted that expressions using terms such as the chip region (CHR), the scribe lane region (SLR), and the like may, depending on the context, refer either to respective portions of the substrate 101 corresponding to those regions, or to the corresponding regions of the wafer or the semiconductor device that include the substrate 101. In plan view, however, each region of the substrate 101 corresponds to a respective region of the wafer (or the semiconductor device), and the regions of the substrate 101 coincide with the respective regions of the wafer (or the semiconductor device).

The scribe lane region SLR may extend in a first horizontal direction (e.g., D1 direction) and a second horizontal direction (e.g., D2 direction) intersecting the first horizontal direction e.g. wherein the second horizontal direction is different from and/or orthogonal to the first horizontal direction. The chip regions CHR may be spaced apart from each other in the first horizontal direction and the second horizontal direction, and may be surrounded by the scribe lane region SLR.

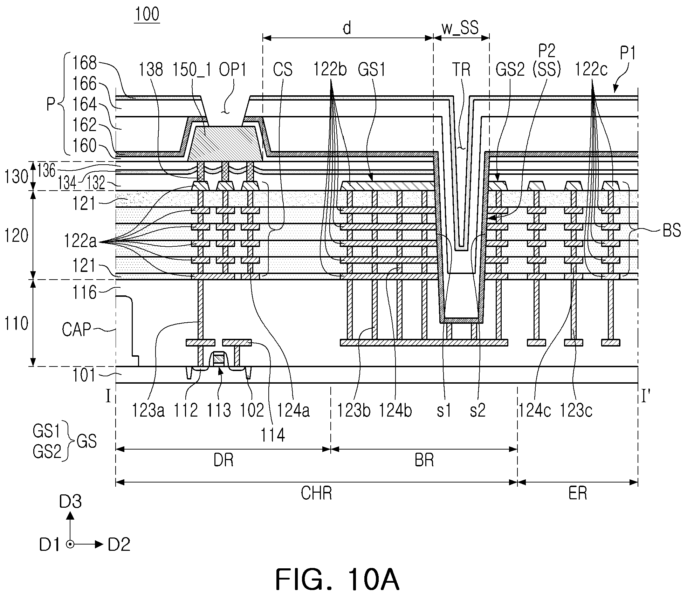

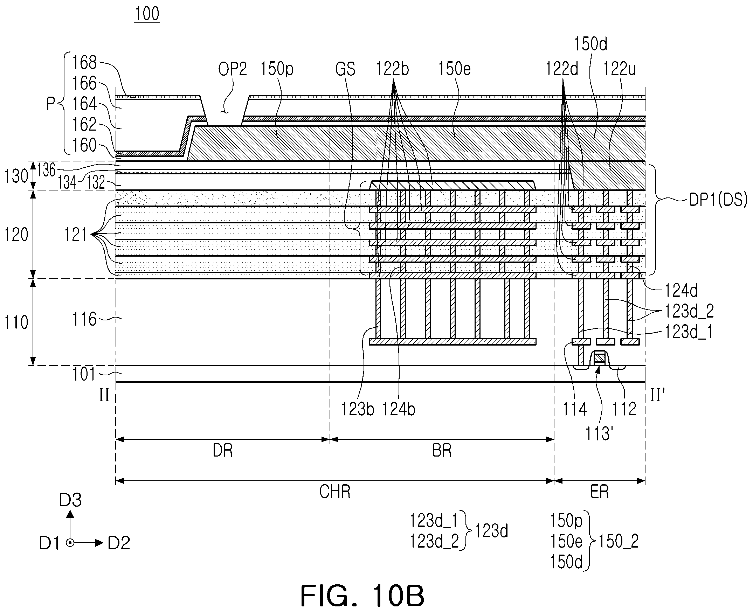

The chip regions CHR may be isolated from each other along (or spaced apart from each other along by) the scribe lane region SLR. The chip regions CHR may be separated from each other by a dicing process described below, thereby forming a plurality of semiconductor devices 100. A portion of the scribe lane region SLR may be referred to as an edge region ER. By the dicing process, for example, the scribe lane region SLR may be separated and a plurality of edge regions ER may remain. (See FIGS. 10A and 10B).

In an example embodiment, a volatile memory device such as a dynamic random access memory (DRAM) or a static random access memory (SRAM), or a non-volatile memory device such as a phase-change random access memory (PRAM), a magnetoresistive random access memory (MRAM), a ferroelectric random access memory (FeRAM), or a resistive random access memory (RRAM) may be provided in the device region DR. In an example embodiment, a logic device such as a microprocessor, an analog device, or a digital signal processor may be provided in the device region DR.

In an example embodiment, the scribe lane region SLR may be provided with a dummy pattern (or supplementary patterns) DP. The supplementary patterns may include a plurality of conductive patterns and/or individual devices that will be described later. The dummy pattern DP may include a first dummy pattern (or first supplementary pattern) DP1 such as a test element group (TEG) pattern, an electrical die sorting (EDS) pattern (e.g., pads that may be used only for an EDS process), and a second dummy pattern (or second supplementary pattern) DP2 for alignment of a mask (or a probe card), or the like. In an example embodiment, the first dummy pattern DP1 may be referred to as a test pattern, and the second dummy pattern DP2 may be referred to as a sort key pattern (or alignment key pattern).

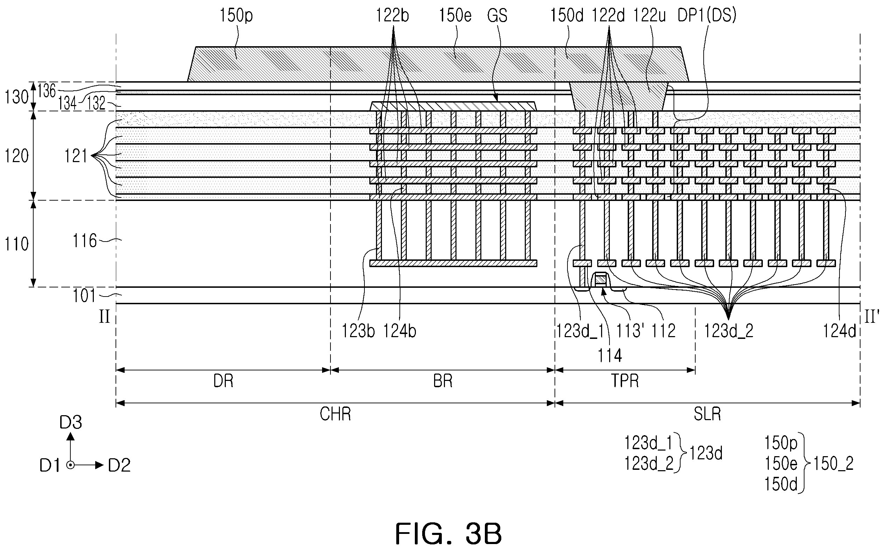

FIGS. 3A and 3B are vertical cross-sectional diagrams illustrating a semiconductor substrate in relation to a method of manufacturing a semiconductor device 100 according to an example embodiment. FIG. 3A illustrates a vertical cross-section taken along line I-I' in FIG. 2. FIG. 3B illustrates a vertical cross-section taken along line II-II' in FIG. 2. FIGS. 3A and 3B may illustrate an intermediate structure that is produced in the course of fabricating a final semiconductor device. The intermediate structure may subsequently be subjected to additional processing steps (e.g., forming passivation layers 164, 166, and 168 and forming an isolation structure SS), as will be described in more detail below.

Referring to FIGS. 3A and 3B, a semiconductor substrate 101 including a chip region CHR and a scribe lane region SLR may be provided. The semiconductor substrate 101 may correspond to a portion of the semiconductor wafer W described with reference to FIGS. 1 and 2.

The semiconductor substrate 101 may include a chip region CHR and a scribe lane region SLR between the chip regions CHR. The chip region CHR may include a device region DR and a buffer region BR surrounding the device region DR in a plan view. The semiconductor substrate 101 may include a semiconductor material. For example, the semiconductor substrate 101 may be a silicon substrate, a germanium substrate, a silicon germanium substrate, or a silicon-on-insulator (SOI) substrate. The semiconductor substrate 101 may include a semiconductor material such as a group IV semiconductor, a group III-V compound semiconductor, or a group II-VI compound semiconductor.

A conductive region 112 and an isolation region 102 may be formed in the semiconductor substrate 101. The conductive region 112 may be, for example, a well doped with impurities (e.g., charge carrier dopants) or a structure doped with impurities. The conductive regions 112 may be a part of the integrated circuit elements 113. The isolation region 102 may be a device isolation structure having a shallow trench isolation (STI) structure and may include silicon oxide.

Referring to FIGS. 3A and 3B, a device layer 110 may be formed on (or provided with) the semiconductor substrate 101.

The device layer 110 may include integrated circuit elements 113, internal interconnection patterns (or lower interconnection patterns) 114, and a lower interlayer insulating layer 116. For example, the internal interconnection patterns 114 may be formed of the same material and/or formed in the same process steps. For example, the internal interconnection patterns 114 may be formed by patterning a conductive layer. For example, the internal interconnection patterns 114 may have the same configuration of material as each other, while their shapes and/or sizes may differ from each other. For example, the internal interconnection patterns 114 may be formed by patterning a conductive layer such that the internal interconnection patterns 114 are positioned at the same vertical level.

The integrated circuit elements 113 may include (or constitute at least a part of) a memory cell array including switching devices and data storage elements, and logic devices including a MOSFET, a capacitor, and a resistor. The internal interconnection pattern 114 may be disposed on the integrated circuit elements 113 and may be electrically connected to at least one of the integrated circuit elements 113. The integrated circuit elements 113 may be disposed in the device region DR, and a portion of the integrated circuit elements 113 may be disposed in the scribe lane region SLR. Second individual devices 113' may be disposed in the scribe lane region SLR. The second individual devices 113' may have substantially the same structure as or similar structure to the integrated circuit elements 113. For example, the second individual devices 113' may be used only for a wafer test. The internal interconnection pattern 114 may be disposed in the device region DR and the buffer region BR, and in some example embodiments, the internal interconnection pattern 114 may also be disposed in the scribe lane region SLR. A lower interlayer insulating layer 116 may cover the semiconductor substrate 101, the integrated circuit elements 113, and the internal interconnection patterns 114. The internal interconnection patterns 114 may include copper (Cu), aluminum (Al), tungsten (W), nickel (Ni), titanium (Ti), titanium nitride (TiN), tantalum (Ta), tantalum nitride (TaN), gold (Au), or a combination thereof. For example, the internal interconnection patterns 114 may include copper (Cu). The lower interlayer insulating layer 116 may include silicon oxide, silicon nitride, silicon oxynitride, or a combination thereof. For example, the lower interlayer insulating layer 116 may include silicon oxide.

The device layer 110 may further include a data storage structure CAP on the device region DR. The data storage structure CAP may store data and may be, for example, a capacitor structure of a DRAM. From another perspective, the data storage structure CAP may be a capacitor for storing data in a memory, such as a DRAM.

The data storage structure CAP may include a lower electrode structure, a dielectric layer on the lower electrode structure, and an upper electrode structure on the dielectric layer. The lower electrode structure of the data storage structure CAP may be electrically connected to a conductive region formed in the semiconductor substrate 101. The data storage structure CAP may be covered by the lower interlayer insulating layer 116.

The device layer 110 may further include conductive connection structures (or conductive connection patterns) 123a, 123b, 123c, and 123d. At least some of the conductive connection structures 123a, 123b, 123c, and 123d may be buried by or formed within the lower interlayer insulating layer 116. For example, the conductive connection patterns 123a, 123b, 123c, and 123d may be formed of the same material and/or formed in the same process steps. In some embodiments, the conductive connection structures 123a, 123b, 123c, and 123d may be formed by a patterning process on a conductive layer. For example, the conductive connection patterns 123a, 123b, 123c, and 123d may have the same configuration of material as each other, while their shapes and/or sizes may differ from each other. For example, the conductive connection structures 123a, 123b, 123c, and 123d may be positioned at the same vertical level.

The conductive connection structures 123a, 123b, 123c, and 123d may include interconnection connection layers 123a on the device region DR, guard-ring connection layers (or middle guard-ring patterns) 123b on the buffer region BR, blocking connection layers (or first middle blocking patterns 123c in FIG. 3A) and dummy connection layers (or second middle blocking patterns 123d in FIG. 3B) on the scribe lane region SLR.

The interconnection connection layers (or middle chip connection patterns) 123a may be formed to be electrically connected to the internal interconnection pattern 114 on the device region DR. For example, the interconnection connection layers 123a may constitute at least a part of an integrated circuit of a semiconductor device according to an example embodiment.

The guard-ring connection layers 123b may be formed on the buffer region BR to surround the device region DR. For example, the middle guard-ring patterns 123b may constitute at least a part of a guard ring structure in the semiconductor device. The guard ring structure may include a group of the upper interconnection patterns (e.g., middle guard-ring patterns 123b). In the guard ring structure, the middle guard-ring patterns 123b may be arranged repeatedly in horizontal directions D1 and D2, and electrically connected to each other.

For example, the guard ring structure may include doped regions (e.g., p-type doped regions or n-type doped regions) in the semiconductor substrate 101 and conductive lines (e.g., middle guard-ring patterns 123b) electrically connected to the doped regions. The guard ring structure may surround components in the device region DR in a plan view. The guard ring structure may serve to stabilize substrate potential, suppress leakage currents, mitigate electric-field crowding, and/or isolate circuits from substrate noise and parasitic interactions.

The blocking connection layers 123c may be formed on the scribe lane region SLR to be disposed on one side of the guard-ring connection layers 123b. For example, the first middle blocking patterns 123c may constitute at least a part of a first blocking structure. The first blocking structure may include a group of the upper interconnection patterns (e.g., first middle blocking patterns 123c). In the first blocking structure, the first middle blocking patterns 123c may be arranged repeatedly in horizontal directions D1 and D2, and/or may be electrically connected to each other such that the first blocking structure may surround components in the device region DR in a plan view. The first blocking structure may serve to suppress stress occurring in the scribe lane region SLR due to a dicing process from being transferred to the chip region CHR. For example, the first middle blocking patterns 123c may be electrically isolated from the components (including interconnection connection layers 123a) in the device region DR. For example, the first middle blocking patterns 123c may be electrically isolated from the components (including conductive lines such as middle guard-ring patterns 123b) in the chip regions CHR.

The dummy connection layers (or second middle blocking patterns) 123d may constitute, for example, at least a part of a second blocking structure. The second blocking structure may include a group of the upper interconnection patterns (e.g., second middle blocking patterns 123d). In the second blocking structure, the second middle blocking patterns 123d may be arranged repeatedly in horizontal directions D1 and D2, and/or may be electrically connected to each other. In some embodiments, the second middle blocking patterns 123d may include a first set (e.g., first middle sub-blocking patterns 123d_1) and a second set (e.g., second middle sub-blocking patterns 123d_2) such that the first set may be electrically isolated from the second set, while each pattern of the first set or the second set may be electrically connected to each other.. The second blocking structure may serve to suppress stress occurring in the scribe lane region SLR due to a dicing process from being transferred to the chip region CHR. For example, the second middle blocking patterns 123d may be electrically isolated from the first middle blocking patterns 123c and the middle guard-ring patterns 123b. The second middle blocking patterns 123d may include a first dummy connection layer (or first middle sub-blocking patterns) 123d_1 connected to the second individual devices 113' and at least one second dummy connection layer (or second middle sub-blocking patterns) 123d_2 disposed on an external side of the first dummy connection layer 123d_1. For example, the second middle sub-blocking patterns 123d_2 may be disposed farther from the guard-ring structure GS than the first middle sub-blocking patterns 123d_1 are. From another perspective, some of the second middle sub-blocking patterns 123d_2 may be electrically isolated from the components in the device region DR.

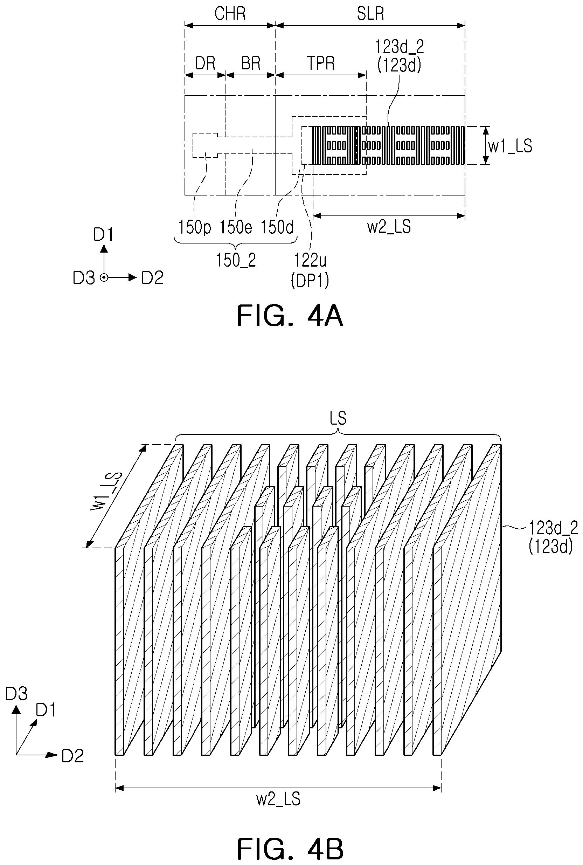

The dummy connection layers 123d may have a pillar shape extending in the vertical direction (e.g., D3), but example embodiments are not limited thereto. For example, at least one of the second middle blocking patterns 123d may have a pillar shape extending in the vertical direction (e.g., D3). For example, the second middle blocking patterns 123d, as a group, may collectively have a pillar shape extending in the vertical direction. For example, the second middle sub-blocking patterns 123d_2, as a group, may collectively have a pillar shape extending in the vertical direction. For example, the at least one second dummy connection layer (or second middle sub-blocking patterns) 123d_2 (or second middle blocking patterns 123d) may include patterns extending and repeating in at least one horizontal direction (e.g., D1 and/or D2) (see FIGS. 4A, 4B, 5, and 6). In some embodiments, at least some of the second middle sub-blocking patterns 123d_2, as a group, may extend and be arranged repeatedly in at least one of the direction D1 and the direction D2.

The region in the scribe lane region SLR in which the first dummy pattern DP1 (or 'test pattern') is disposed may be referred to as a test pad region TPR. From another perspective, the second individual devices 113' and the first dummy connection layer 123d_1 may be formed in the test pad region TPR.

As shown in FIGS. 4A, 4B, 5, 6, 12, 13, 14A, 14B, 15 and 16, the second middle blocking pattern 123d may have various configurations. For example, the second middle sub-blocking pattern 123d_2 (or the second middle blocking pattern 123d) may be formed as a single continuous body, or may be configured by a plurality of similar (or the same) patterns that are repetitively and/or regularly arranged in at least one of the directions D1, D2 and D3. Hereinafter, some examples of the various embodiments of the second dummy connection layer 123d_2 may be described with reference to FIGS. 4A, 4B, 5, and 6. For example, the single continuous body may be provided in plural such that they are repetitively and/or regularly arranged in at least one of the directions D1, D2 and D3, though not shown in the drawings.

FIG. 4A is a plan diagram illustrating a horizontal cross-section of a second dummy connection layer 123d_2 in a plane parallel to the plane defined by the directions D1 and D2. FIG. 4B is a perspective diagram illustrating a three-dimensional shape of the second dummy connection layer 123d_2.

Referring to FIGS. 4A and 4B, the second middle sub-blocking pattern 123d_2 (or second middle blocking patterns 123d) may be configured by a plurality of patterns having similar (or substantially the same) shapes and arranged repetitively and/or regularly in at least one of the directions D1 and D2. For example, in a plan view, at least one second dummy connection layer 123d_2 may have a line structure extending in one direction (e.g., D1) in a cross-sectional view taken along directions D1 and D2.

In an example embodiment, each of the second middle sub-blocking patterns 123d_2 may have a first width in the first direction D1 which may be greater than a second width in the second direction (e.g., D2). The first width in the first direction D1 may be greater than a thickness in the vertical direction D3.

In an example embodiment, each of the second middle sub-blocking patterns 123d_2 may have the line structure in a cross-sectional view taken along directions D2 and D3. Each of the plurality of second dummy connection layers 123d_2 may extend in the third direction D3 and may be spaced apart from each other in the second direction D2 perpendicular to the third direction. The line structures may be collectively referred to as line structures LS.

In the first direction D1, a first width w1_LS of the line structure LS (or the line structure) may be substantially the same as a width of the first dummy pattern DP1 (or 'redistribution via 122u'). For example, the second middle sub-blocking patterns 123d_2, as a group, may collectively have a plate-shape, a cubic shape, a cylindrical shape, or a rectangular parallelepiped shape. The width w1_LS of the second middle sub-blocking patterns 123d_2, as a group, may be substantially the same as the width of the first dummy pattern DP1 (or 'redistribution via 122u') in the first direction D1.

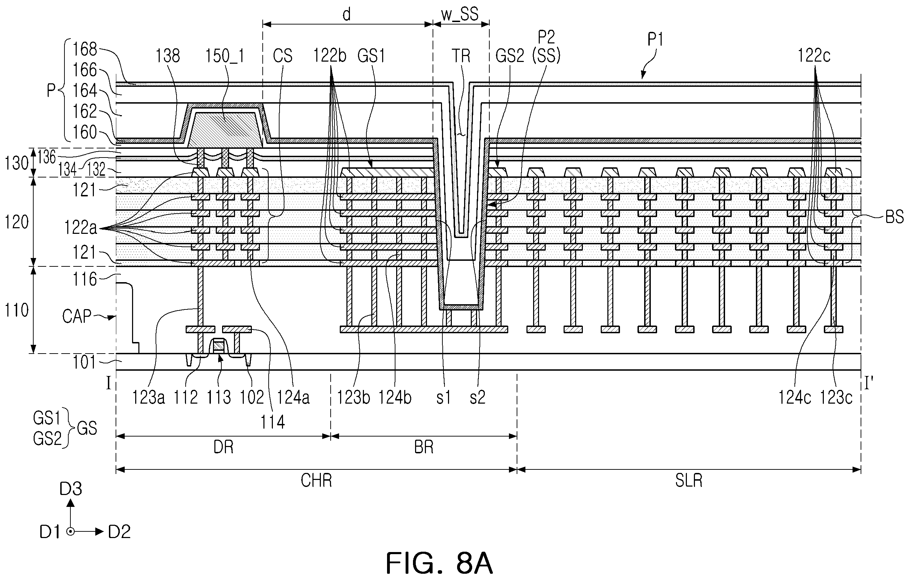

In the second direction D2, a width w2_LS of the line structure LS may be greater than a width w_SS of the isolation structure ('SS' in FIG. 8A).

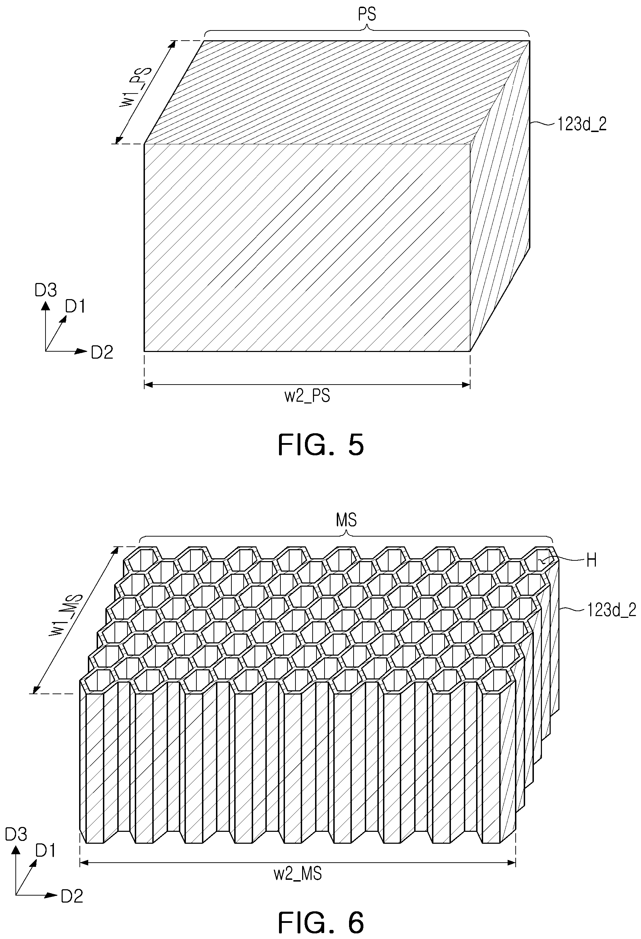

Referring to FIG. 5, at least one second dummy connection layer (or second middle sub-blocking patterns) 123d_2 (or second middle blocking patterns 123d) may have a plate-shaped structure PS having a thickness in the vertical direction (e.g., D3) (e.g., a plate-shaped structure PS extending along the first direction D1 and second direction D2). In an example embodiment, the plate-shaped structure PS may have, for example, a cubic or rectangular parallelepiped shape. In some embodiments, the second middle sub-blocking patterns 123d_2 may be connected to each other integrally to form a single continuous body. In some embodiments, each second middle sub-blocking pattern 123d_2 or the single continuous body may have a plate-shape, a cubic shape, a cylindrical shape, or a rectangular parallelepiped shape. For example, the second middle sub-blocking patterns 123d_2 may be repetitively and/or regularly arranged in at least one of the directions D1, D2 and D3, though not shown in the drawings.

The width w1_PS of the plate-shaped structure PS may be substantially the same as the width of the first dummy pattern DP1 (or 'redistribution via 122u') in the first direction D1.

The width w2_PS of the plate-shaped structure PS may be greater than the width w_SS of the isolation structure ('SS' in FIG. 8A) in the second direction D2.

Referring to FIG. 6, at least one second dummy connection layer (or second middle sub-blocking patterns) 123d_2 (or second middle blocking patterns 123d) may include a plurality of second dummy connection layers 123d_2 that are connected to each other integrally. The connected group of the second dummy connection layers 123d_2 may have a mesh structure MS in which a plurality of through-holes H are arranged repeatedly in at least one horizontal direction (e.g., D1 and/or D2).

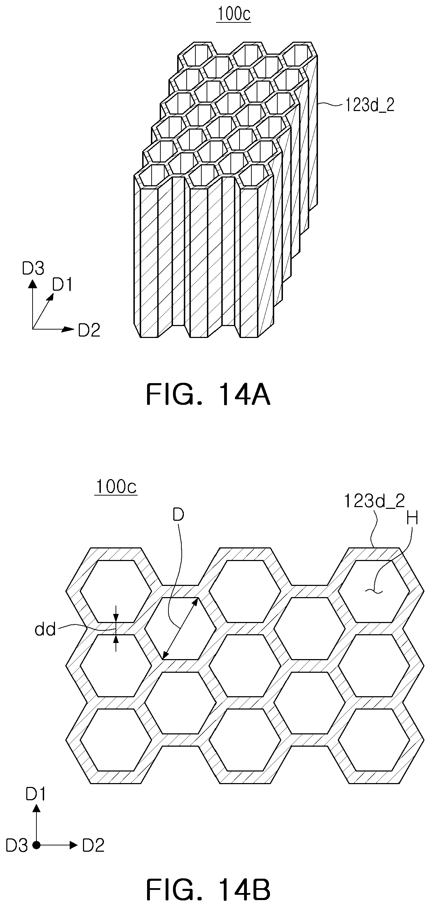

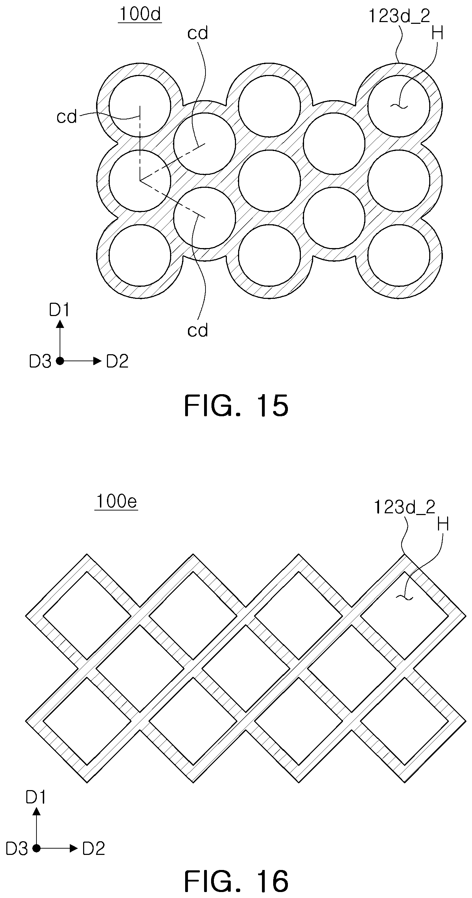

In an example embodiment, the plurality of through-holes H may have substantially the same shape in a plan view. For example, each of the plurality of through-holes H may have a hexagonal shape in a plan view. From another perspective, the mesh structure MS may be formed as a honeycomb structure in a cross-sectional view (see FIG. 14B). In an example embodiment, each of the plurality of through-holes H may have a circular or polygonal shape in plan view (see FIGS. 15 and 16).

The width w1_MS of the mesh structure MS may be substantially the same as the width of the first dummy pattern DP1 (or 'redistribution via 122u') in the first direction D1.

The width w2_MS of the mesh structure MS may be greater than the width w_SS of the isolation structure ('SS' in FIG. 8A) in the second direction D2.

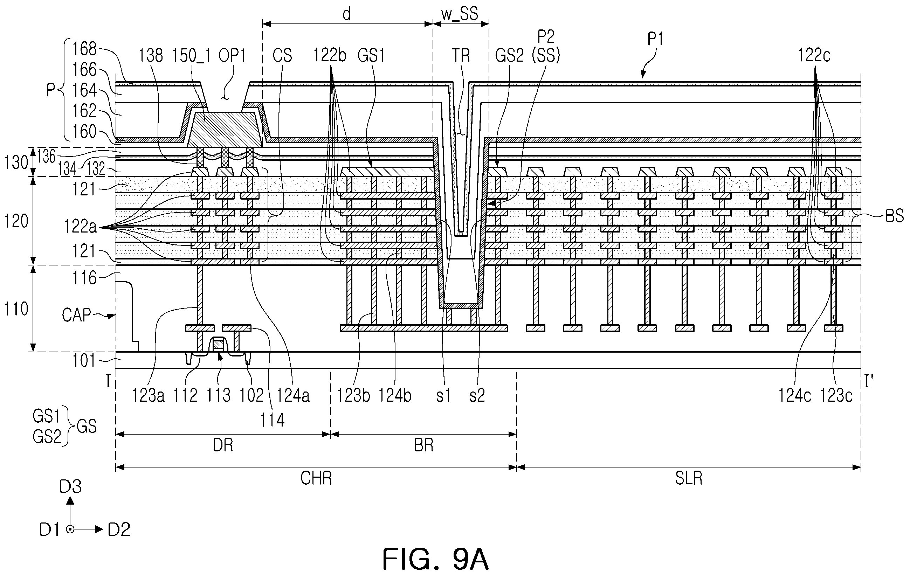

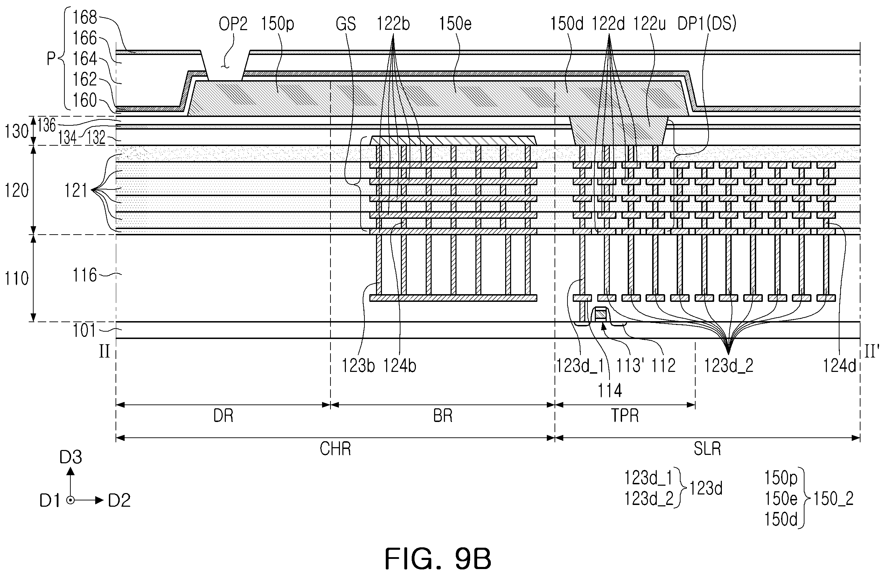

In example embodiments, by disposing a dummy connection layer 123d (or a second dummy connection layer 123d_2) extending in at least one direction and having a repetitive pattern on a lower portion of the first dummy pattern DP1 (or a test pattern) on a scribe lane region SLR including a test pad region TPR, stress occurring in the scribe lane region SLR due to a dicing process may be reduced or prevented from being transferred to the chip region CHR through the test pad region TPR (see FIGS. 9A and 9B).

Referring back to FIGS. 3A and 3B, an interconnection layer 120 may be formed on the device layer 110.The interconnection layer 120 may include interlayer insulating layers 121 and an upper interconnection layer. The upper interconnection layer may be provided in plural. For example, six of the upper interconnection layers may be provided as shown in the drawings, though the number of upper interconnection layers may vary and is not to be regarded as limiting the present invention. Each of the plurality of upper interconnection layers 122a, 122b, 122c, and 122d may be patterned to form a plurality of upper interconnection patterns such that the patterns in each layer may have the same material configuration and/or formed in the same process steps, while their shapes and/or sizes may differ from each other. For example, each of the plurality of conductive pattern layers 122a, 122b, 122c, and 122d may have a set of upper interconnection patterns that are positioned at the same vertical level. For example, the topmost one of the upper interconnection layers may not be provided on a portion of the scribe lane region such that the second middle blocking patterns 123d are formed from five of the upper interconnection layers.

The interlayer insulating layers 121 may be deposited in order or stacked on the lower interlayer insulating layer 116. The interlayer insulating layer 121 may include a low-k dielectric material. For example, the interlayer insulating layer 121 may include silicon oxide or an organic polymer doped with impurities. In an example embodiment, the interlayer insulating layer 121 may include SiOCH, SiCN, or a combination thereof.

The plurality of conductive pattern layers 122a, 122b, 122c, and 122d may include a plurality of interconnection pattern layers 122a on the device region DR, a plurality of guard-ring pattern layers (or upper guard-ring patterns) 122b on the buffer region BR, a plurality of blocking pattern layers (or first upper blocking patterns 122c shown in FIG. 3A) on the scribe lane region SLR, and a plurality of dummy pattern layers (or second upper blocking patterns 122d shown in FIG. 3B). The plurality of conductive pattern layers 122a, 122b, 122c, and 122d may be buried in or formed within the interlayer insulating layers 121. The plurality of conductive pattern layers (or upper interconnection patterns) 122a, 122b, 122c, and 122d may include copper (Cu), aluminum (Al), tungsten (W), nickel (Ni), titanium (Ti), titanium nitride (TiN), tantalum (Ta), tantalum nitride (TaN), gold (Au), or a combination thereof. For example, the plurality of conductive pattern layers 122a, 122b, 122c, and 122d may include copper (Cu).

The plurality of interconnection pattern layers 122a may be stacked in the vertical direction (e.g., D3) on the device region DR. The plurality of interconnection pattern layers 122a may be formed on the plurality of interconnection connection layers 123a. The plurality of interconnection pattern layers 122a may be electrically connected to the integrated circuit element 113 by the plurality of interconnection connection layers 123a. The plurality of interconnection pattern layers 122a may be connected in the vertical direction (e.g., D3) through a plurality of interconnection via layers (or chip via patterns) 124a. The plurality of interconnection pattern layers 122a may include a plurality of layers. For example, the plurality of interconnection pattern layers 122a may include six layers, but an example embodiment thereof is not limited thereto. An uppermost interconnection pattern layer of the plurality of interconnection pattern layers 122a may include, for example, aluminum (Al).

The plurality of interconnection pattern layers 122a and the plurality of interconnection via layers 124a may be collectively referred to as an interconnection structure CS. In an example embodiment, the plurality of interconnection pattern layers 122a, the plurality of interconnection via layers 124a, and the plurality of interconnection connection layers 123a may be collectively referred to as an interconnection structure CS.

The plurality of guard-ring pattern layers 122b may be stacked in the vertical direction (e.g., D3) on the buffer region BR. The plurality of guard-ring pattern layers 122b may be formed on the plurality of guard-ring connection layers 123b. The plurality of guard-ring pattern layers 122b may be connected in the vertical direction (e.g., D3) through a plurality of guard-ring via layers (or guard-ring via patterns) 124b. The plurality of guard-ring pattern layers 122b may include a plurality of layers. For example, the plurality of guard-ring pattern layers 122b may include six layers, but example embodiments are not limited thereto. An uppermost guard-ring pattern layer of the plurality of guard-ring pattern layers 122b may include, for example, aluminum (Al).

The plurality of guard-ring pattern layers 122b and the plurality of guard-ring via layers 124b may be collectively referred to as a guard-ring structure GS. In an example embodiment, the plurality of guard-ring pattern layers 122b, the plurality of guard-ring via layers 124b, and the plurality of guard-ring connection layers 123b may be collectively referred to as a guard-ring structure GS.

The plurality of blocking pattern layers 122c may be stacked in the vertical direction (e.g., D3) on the scribe lane region SLR (see FIG. 3A). The plurality of blocking pattern layers 122c may be formed on the plurality of blocking connection layers 123c. The plurality of blocking pattern layers 122c may be connected vertically (e.g., D3) through a plurality of blocking via layers 124c. The plurality of blocking pattern layers 122c may include a plurality of layers. For example, the plurality of blocking pattern layers 122c may include six layers, but example embodiments are not limited thereto. An uppermost blocking pattern layer of the plurality of blocking pattern layers 122c may include, for example, aluminum (Al).

The plurality of blocking pattern layers 122c and the plurality of blocking via layers (or first blocking via patterns) 124c may be collectively referred to as a crack blocking structure BS. In an example embodiment, the plurality of blocking pattern layers 122c, the plurality of blocking via layers 124c, and the plurality of blocking connection layer 123c may be collectively referred to as a crack blocking structure BS.

The plurality of dummy pattern layers 122d may be stacked in the vertical direction (e.g., D3) on the test pad region TPR of the scribe lane region SLR (see FIG. 3B). The plurality of dummy pattern layers 122d may be formed on the plurality of dummy connection layers 123d. The plurality of dummy pattern layers 122d may be connected to each other in the vertical direction (e.g., D3) through a plurality of dummy via layers (or second blocking via patterns) 124d. The plurality of dummy pattern layers 122d may include a plurality of layers. For example, the plurality of dummy pattern layers 122d may include five layers, but an example embodiment thereof is not limited thereto.

The plurality of dummy pattern layers 122d and the plurality of dummy via layers 124d may be collectively referred to as a dummy structure DS (or, first dummy pattern DP1). In an example embodiment, the plurality of dummy pattern layers 122d, the plurality of dummy via layers 124d, and the plurality of dummy connection layers 123d may be collectively referred to as a dummy structure DS.

Referring to FIGS. 3A and 3B, an insulating structure 130 may be formed on the interconnection layer 120.

An insulating structure 130 may include a first upper insulating layer 132 covering the uppermost ones among the upper interconnection patterns 123a, 123b, and 123c). The insulating structure 130 may further include a second upper insulating layer 134. The second upper insulating layer 134 may be formed on the first upper insulating layer 132. The insulating structure 130 may further include a third upper insulating layer 136. The third upper insulating layer 136 may be formed on the second upper insulating layer 134.

In an example embodiment, a portion of a second upper insulating layer 134 (that overlaps the uppermost conductive pattern layers when viewed in the vertical direction) may protrude upwardly, though not shown in the drawings. The second upper insulating layer 134 may include a material having etch selectivity with respect to the first upper insulating layer 132. For example, the first upper insulating layer 132 may include a high-density plasma (HDP) oxide. The second upper insulating layer 134 may include silicon nitride, silicon oxynitride, silicon carbonitride, or a combination thereof. In an example embodiment, the third upper insulating layer 136 may include silicon oxide. For example, the third upper insulating layer 136 may include tetraethyl orthosilicate (TEOS). In an example embodiment, a thickness of the first upper insulating layer 132 may be greater than a thickness of the second upper insulating layer 134. In an example embodiment, a thickness of the first upper insulating layer 132 may be greater than a thickness of the third upper insulating layer 136. In an example embodiment, a thickness of the third upper insulating layer 136 may be greater than a thickness of the second upper insulating layer 134.

An opening penetrating the insulating structure 130 and exposing an upper surface of the uppermost interconnection pattern layers may be formed, and the opening may be filled with a conductive material, thereby forming a conductive via 138.

An opening penetrating the insulating structure 130 and exposing uppermost dummy via layers among the plurality of dummy via layers 124d may be formed, and the opening may be filled with a conductive material, thereby forming a redistribution via (or pad via pattern) 122u. A width of the redistribution via 122u may increase in a direction away from an upper surface of the semiconductor substrate 101 in the vertical direction (e.g., D3).

In an example embodiment, the redistribution via 122u may be referred to as an uppermost dummy pattern layer among the plurality of dummy pattern layers 122d.

Referring to FIGS. 3A and 3B, pad structures 150 may be formed on the insulating structure 130. The pad structures 150 may include first and second pad structures (or first and second pads) 150_1 and 150_2.

The first pad structure 150_1 may be formed on the interconnection structure CS on the device region DR (see FIG. 3A). The first pad structure 150_1 may be electrically connected to the interconnection structure CS by the conductive via 138. The first pad structure 150_1 may be referred to as an active pad structure.

A second pad structure 150_2 extending from the device region DR to the buffer region BR and the scribe lane region SLR (or 'test pad region TPR') may be formed (see FIG. 3B). The second pad structure 150_2 may be defined to include a first pad portion 150p on the device region DR, an extension portion 150e extending from the first pad portion 150p to (or across) the buffer region BR, and a second pad portion 150d extending from the extension portion 150e to the scribe lane region SLR.

The second pad structure 150_2 may be referred to as a dummy pad structure. In this case, the first pad portion 150p may be referred to as a first dummy pad portion, and the second pad portion 150d may be referred to as a second dummy pad portion.

For example, a conductive layer may be patterned to form the first and second pads 150_1 and 150_2 such that the first and second pads 150_1 and 150_2 may have the same material configuration and/or be formed in the same process steps, while their shapes and/or sizes may differ from each other. For example, the first and second pads 150_1 and 150_2 may be positioned at the same vertical level.

The first pad portion 150p may be spaced apart from the first pad structure 150_1. The second pad portion 150d may be in contact with redistribution via 122u. From another perspective, the second pad portion 150d may be electrically connected to the plurality of dummy pattern layers 122d by the redistribution via 122u.

A width of the second pad portion 150d may be greater than a width of each of the first pad portion 150p and the extension portion 150e in the first direction D1. The width of the second pad portion 150d may be greater than a width of the first pad portion 150p in the second direction D2.

The first pad portion 150p, the extension portion 150e, and the second pad portion 150d may be divided to describe the shape and arrangement of the second pad structure 150_2. From another perspective, boundaries between the first pad portion 150p, the extension portion 150e, and the second pad portion 150d may not be distinct.

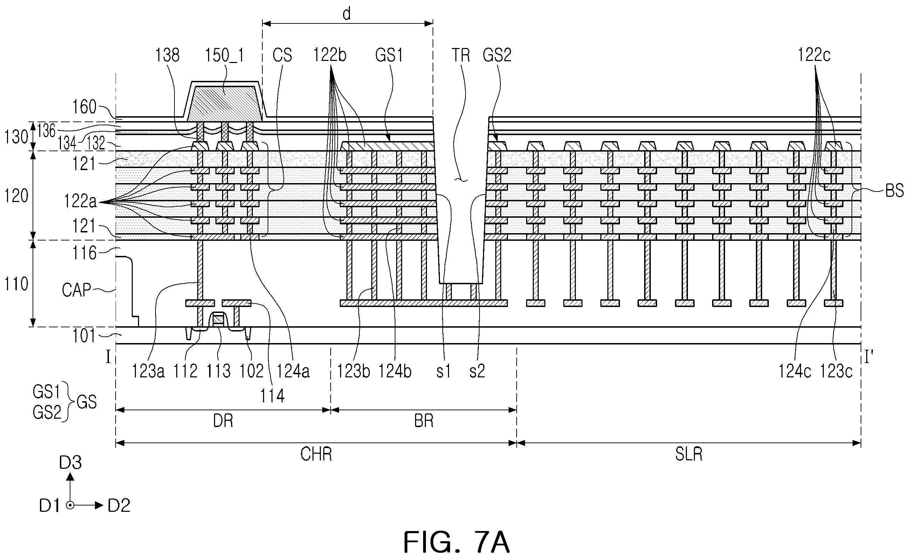

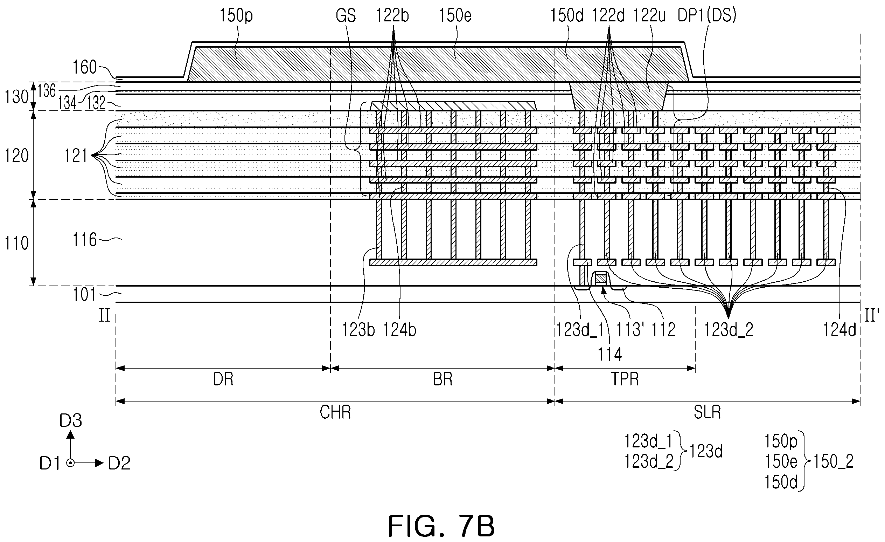

FIGS. 7A and 7B are vertical cross-sectional diagrams illustrating a semiconductor substrate in relation to a method of manufacturing a semiconductor device 100 according to an example embodiment.

Referring to FIGS. 7A and 7B, a protective layer 160 may be formed on the insulating structure 130, and a trench TR may be formed on the buffer region BR.

The protective layer 160 may cover an external surface or outer surface of the pad structures 150.

The trench TR may penetrate a plurality of guard-ring pattern layers 122b of the guard-ring structure GS. From another perspective, the trench TR may be formed to penetrate the protective layer 160, the insulating structure 130, the interconnection layer 120, and the device layer 110 such that a portion of a plurality of guard-ring pattern layers 122b may be exposed. In an example embodiment, a portion of a plurality of guard-ring connection layers 123b may be exposed to the trench TR. In an example embodiment, a lower end level of the trench TR may be positioned in an almost intermediate level (or at a vertical level) between lower and upper surfaces of the device layer 110. For example, a set of the middle guard-ring patterns 123b may be partially removed during the process for forming the trench TR. A distance d between the interconnection structure CS and the trench TR may be in a range of 3 µm to 5 µm in the direction D2.

The trench TR may include a first side s1 adjacent to the interconnection structure CS and a second side s2 opposite the first side s1. The guard-ring structure GS may be isolated into a plurality of elements spaced apart from each other by the trench TR. For example, the guard-ring pattern layers 122b may be divided into a plurality of segments by the trench TR. The guard-ring structure GS may include, for example, a first portion GS1 disposed on the first side s1 and having a first width in the direction D2, and a second portion GS2 disposed on the second side s2 and having a second width in the direction D2. The first width and the second width may be different. For example, the first width may be greater than the second width.

Referring to FIG. 2 together with FIGS. 7A and 7B, one end of the trench TR may be formed adjacent to the second pad structure 150_2. The trench TR may be formed adjacent to, for example, one side of the extension portion 150e of the second pad structure 150_2. The trench TR may not penetrate the guard-ring connection layers (or guard-ring pattern layers) 122b below the second pad structure 150_2 and the lower portion of the second pad structure 150_2. From another perspective, the trench TR may not be formed continuously. Accordingly, the second pad structure 150_2 as a single body may be used to perform a wafer test such that a circuit or an individual device formed in the device region DR may be electrically tested by using the second pad structure 150_2. In an example embodiment, a side surface of the extension portion 150e of the second pad structure 150_2 may be exposed by the trench TR.

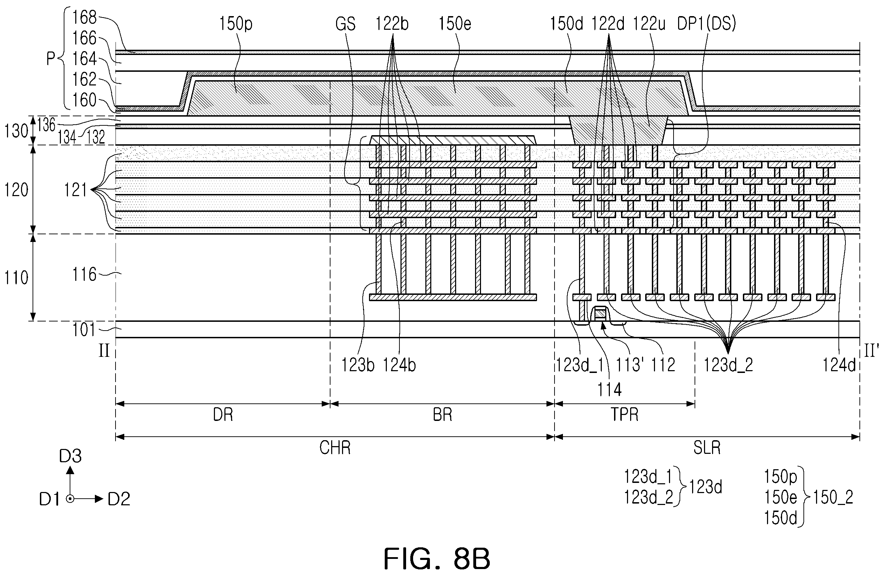

FIGS. 8A and 8B are vertical cross-sectional diagrams illustrating a semiconductor substrate in relation to a method of manufacturing a semiconductor device 100 according to an example embodiment.

Referring to FIGS. 8A and 8B, an etch stop layer 162 may be formed on the protective layer 160 and in the trench TR, and a plurality of passivation layers 164, 166, and 168 may be formed on the etch stop layer 162, thereby forming a passivation structure P.

The etch stop layer 162 may be conformally formed along the protective layer 160 and the trench TR. A portion of the etch stop layer 162 may cover a sidewall and a bottom surface of the trench TR. In an example embodiment, the etch stop layer 162 may include silicon nitride.

The plurality of passivation layers 164, 166, and 168 may be formed in order or stacked on the etch stop layer 162, to thereby form the passivation structure P.

An insulating material layer may be formed on the etch stop layer 162. A first passivation layer 164 may be formed by performing a planarization process on the insulating material layer. For example, the first passivation layer 164 may be formed by forming an insulating material layer on the etch stop layer 162 and subsequently performing a planarization process on the insulating material layer. The planarization process may include a chemical mechanical polishing (CMP) process. An upper surface of the first passivation layer 164 may be substantially coplanar with an upper surface of the etch stop layer 162. The first passivation layer 164 may include silicon oxide, and in an example embodiment, the first passivation layer 164 may include TEOS.

A second passivation layer 166 and an upper passivation layer 168 may be formed in order on the first passivation layer 164. The second passivation layer 166 may include silicon oxide, for example, TEOS. The upper passivation layer 168 may include silicon nitride, silicon oxynitride, silicon carbonitride, or a combination thereof. For example, the upper passivation layer 168 may include silicon nitride. A portion of each of the first passivation layer 164, the second passivation layer 166, and the upper passivation layer 168 may fill the trench TR.

The passivation structure P may include a first portion P1 extending in a horizontal direction along the device region DR, the buffer region BR, and the scribe lane region SLR, and a second portion P2 extending downwardly from the first portion P1 in the buffer region BR. From another perspective, the second portion P2 may refer to a portion disposed in the trench TR. In an example embodiment, the second portion P2 may be referred to as an isolation structure SS.

The second portion P2 may penetrate a plurality of guard-ring pattern layers 122b of the guard-ring structure GS. In an example embodiment, a lower end level of the second portion P2 may be positioned at an intermediate level (or at a vertical level) between lower and upper surfaces of the device layer 110. A distance d between the interconnection structure CS and the second portion P2 may be in a range of 3 µm to 5 µm. A width w_SS of the second portion P2 may be in a range of 1 µm to 3 µm.

In example embodiments, by forming an isolation structure SS to penetrate the guard-ring structure GS on the buffer region BR in which the guard-ring structure GS is formed, the isolation structure SS may be disposed adjacent to the test pad region TPR as shown in FIG. 2. For example, in example embodiments, the isolation structure SS may be adjacent to or in contact with the extension portion 150e of the second pad structure 150_2 in the first direction D1. For example, in example embodiments, the isolation structure SS may include a portion disposed in parallel to the second pad portion 150d of the second pad structure 150_1 such that the portion of the isolation structure SS and the second pad portion 150d extend in the first direction D1. Accordingly, stress occurring in the scribe lane region SLR during a dicing process may be reduced or prevented from being transferred to the chip region CHR through the test pad region TPR (see FIGS. 9A and 9B).

FIGS. 9A and 9B are vertical cross-sectional diagrams illustrating a semiconductor substrate in relation to a method of manufacturing a semiconductor device 100 according to an example embodiment.

Referring to FIGS. 9A and 9B, openings OP1 and OP2 penetrating the passivation structure P and exposing pad structures 150_1 and 150_2 may be formed.

A first opening OP1 penetrating the passivation structure P and exposing the upper surface of the first pad structure 150_1 may be formed. A second opening OP2 penetrating the passivation structure P and exposing an upper surface of the second pad structure 150_2 may be formed. By the second opening OP2, a portion of the upper surface of the first pad portion 150p of the second pad structure 150_2 may be exposed. The openings OP1 and OP2 may be formed by substantially the same process.

A wafer test may be performed using the first pad portion 150p of the second pad structure 150_2 exposed by the second opening OP2. For example, the first pad portion 150p may be electrically connected to a circuit or an individual device formed in the device region DR. In example embodiments, the wafer test may include, for example, an electrical die sorting (EDS) test. For example, the wafer test may include classifying the plurality of semiconductor chips into different classes of semiconductor chip groups based on at least one of parameters such as an operating speed, current consumption, or threshold voltage range.

FIGS. 10A and 10B are vertical cross-sectional diagrams illustrating a semiconductor substrate in relation to a method of manufacturing a semiconductor device 100 according to an example embodiment.

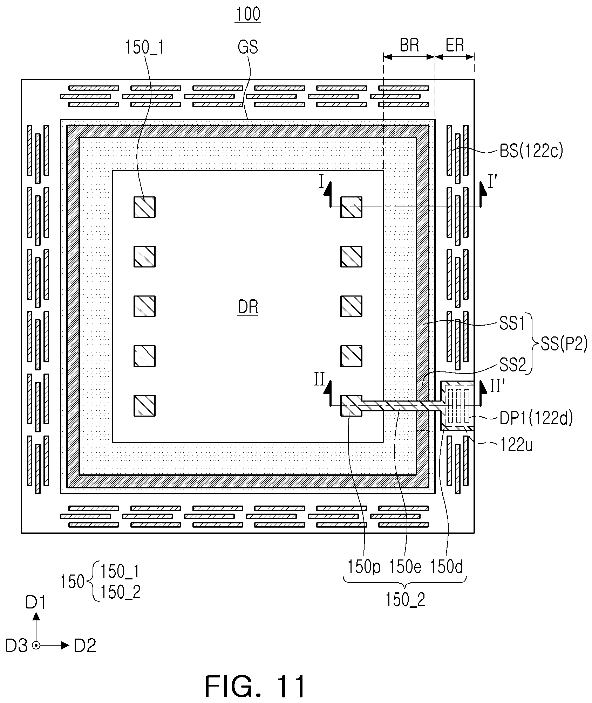

FIG. 11 is a plan diagram illustrating a semiconductor device according to an example embodiment. FIG. 10A is a vertical cross-sectional diagram taken along line I-I' in FIG. 11, and FIG. 10B is a vertical cross-sectional diagram taken along line II-II' in FIG. 11.

Referring to FIGS. 10A, 10B, and 11, a semiconductor device 100 may be formed by a dicing process.

Through the dicing process, the semiconductor substrate 101 or the wafer described in FIGS. 9A and 9B may be diced in the horizontal directions D1 and D2. For example, the wafer dicing process may be performed by cutting the wafer in horizontal directions D1 and D2 to define chip boundaries, while controlling the cutting depth in the vertical direction along the scribe lane region SLR. For example, a laser beam may be irradiated to the back surface of the semiconductor substrate. For example, a thin film tape (not illustrated) may be attached to the semiconductor substrate 101, and a laser beam may be irradiated to a portion of the semiconductor substrate 101 in the scribe lane region (SLR in FIGS. 9A and 9B). The physical properties of the semiconductor substrate 101 may change at the laser spot irradiated with a laser beam, and for example, the physical strength of the semiconductor substrate 101 may be weakened. The thin film tape may be attached to the semiconductor substrate 101 and extend in the horizontal directions such that the semiconductor substrate 101 may be securely isolated along a center of the scribe lane region (SLR in FIGS. 9A and 9B). Alternatively, in some example embodiments, the dicing process may be performed by dicing the semiconductor substrate 101 using a sawing wheel.

An edge region ER may be defined by the dicing process. The edge region ER may surround the buffer region BR, and a portion of the dummy pattern DP1 (or 'dummy structure DS'), which may not be removed and which may remain even after the dicing process, may be disposed in a portion of the edge region ER.

In an example embodiment, the semiconductor substrate 101, the device layer 110, and the interconnection layer 120 may be collectively referred to as a lower structure. In an example embodiment, the insulating structure 130, the conductive via 138, the pad structure 150, and the passivation structure P may be referred to as an upper structure.

The isolation structure SS (or the second portion P2 of the passivation structure P) on the buffer region BR may be defined as including a first portion SS1 and a second portion SS2. The first portion SS1 may, for example, include a portion disposed adjacent to the crack blocking structure BS on the edge region ER. The second portion SS2 may, for example, include a portion disposed adjacent to the second pad structure 150_2. For example, referring to FIG. 11, the isolation structure SS may be divided into a first portion SS1 and a second portion SS2. In a plan view, the first portion SS1 and second portion SS2 may respectively overlap the crack blocking structure BS and the second pad structure 150_2 when viewed along the direction D2.

The second portion SS2 may be disposed adjacent to the extension portion 150e of the second pad structure 150_2 and may be disposed in parallel to the second pad portion 150d of the second pad structure 150_2 in the first direction D1.

The first and second portions SS1 and SS2 may be divided to describe the shape and arrangement relationship of the isolation structure SS, and a boundary between the first and second portions SS1 and SS2 may not be distinct.

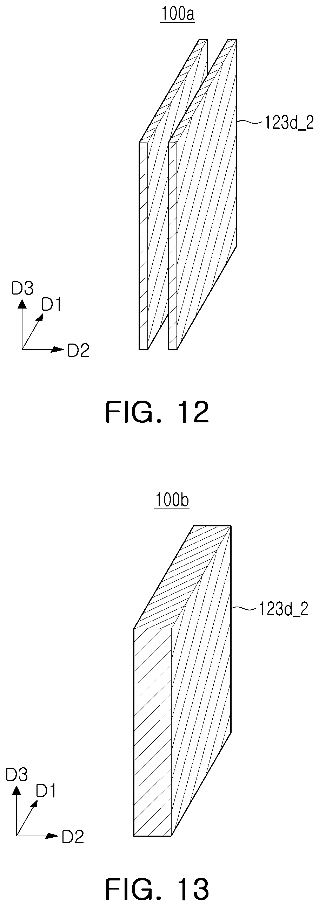

FIG. 12 is a perspective diagram illustrating a three-dimensional shape of dummy connection layers of a semiconductor device 100a according to an example embodiment.

Referring to FIG. 12, each of the plurality of second dummy connection layers 123d_2 of the semiconductor device 100a may have a line structure extending in one direction (e.g., D1) in a plan view.

For example, the plurality of second dummy connection layers 123d_2 of the semiconductor device 100a may include dummy connection layers remaining after a portion of the line structure LS described with reference to FIGS. 4A and 4B is removed by the dicing process.

In the example embodiment, the line structure may be configured substantially the same as the line structure described with reference to FIGS. 4A and 4B.

FIG. 13 is a perspective diagram illustrating a three-dimensional shape of dummy connection layers of a semiconductor device 100b according to an example embodiment.

Referring to FIG. 13, a second dummy connection layer 123d_2 of the semiconductor device 100b may have a plate-shaped structure having a thickness in the vertical direction (e.g., D3).

For example, the second dummy connection layer 123d_2 of the semiconductor device 100b may include a dummy connection layer remaining after a portion of the plate-shaped structure PS described with reference to FIG. 5 is removed by a dicing process

In the example embodiment, the plate-shaped structure may be configured substantially the same as or similar to the plate-shaped structure described with reference to FIG. 5.

FIG. 14A is a perspective diagram illustrating a three-dimensional shape of dummy connection layers of a semiconductor device 100c according to an example embodiment. FIG. 14B is a plan diagram illustrating a horizontal cross-section of the dummy connection layers shown in FIG. 14A in a plane parallel to the plane defined by the directions D1 and D2.

Referring to FIGS. 14A and 14B, each of the plurality of second dummy connection layers 123d_2 of the semiconductor device 100c may have a mesh structure in which a plurality of through-holes H are repeated in at least one horizontal direction (e.g., D1 and/or D2).

For example, the plurality of second dummy connection layers 123d_2 of the semiconductor device 100c may include a dummy connection layer remaining after a portion of the mesh structure MS described with reference to FIG. 6 is removed by a dicing process.

In the example embodiment, the mesh structure may be configured substantially the same as or similar to the mesh structure described with reference to FIG. 6.

The plurality of through-holes H may have substantially the same shape as each other in plan view, for example. For example, each of the plurality of through-holes H may have a hexagonal shape in plan view. Alternatively, the mesh structure may be formed as a honeycomb structure in cross-section. A distance dd between adjacent through-holes H may be equal to or less than the maximum width D of each of the through-holes H.

FIG. 15 is a plan diagram illustrating a horizontal cross-section of dummy connection layers of a semiconductor device 100d according to an example embodiment.

Referring to FIG. 15, each of the plurality of second dummy connection layers 123d_2 of the semiconductor device 100d may have a mesh structure in which through-holes H each having a circular shape is repeated.

A distance cd between centers of the circular through-holes H adjacent to each other may be substantially the same. In some example embodiments, distances between the through-holes H adjacent to each other may not be constant.

FIG. 16 is a plan diagram illustrating a horizontal cross-section of dummy connection layers of a semiconductor device 100e according to an example embodiment.

Referring to FIG. 16, each of the plurality of second dummy connection layers 123d_2 of the semiconductor device 100e may have a mesh structure in which through-holes H each having a quadrangular shape are repeated.

The shape of each of the through-holes H may not be limited to a quadrangular shape. In some example embodiments, a horizontal cross-section through each of the through-holes H may have a polygonal shape, including, for example, a rectangular shape, a trapezoidal shape, or a rhombus shape.

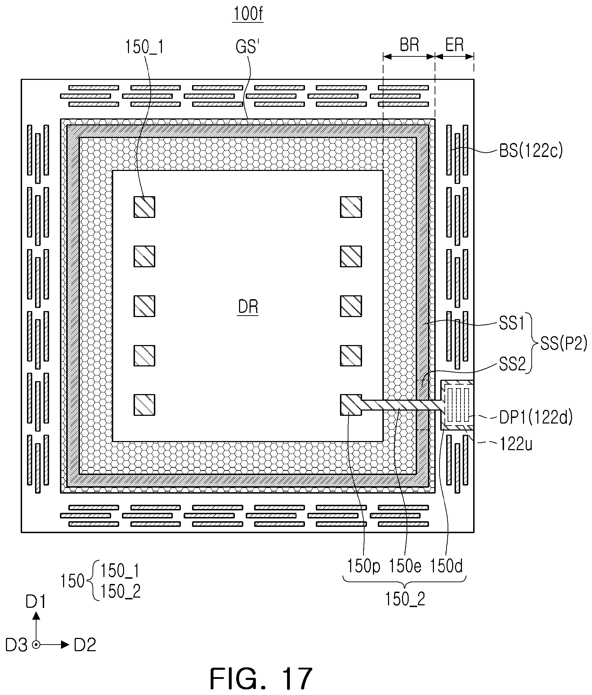

FIG. 17 is a plan diagram illustrating a semiconductor device 100f according to an example embodiment.

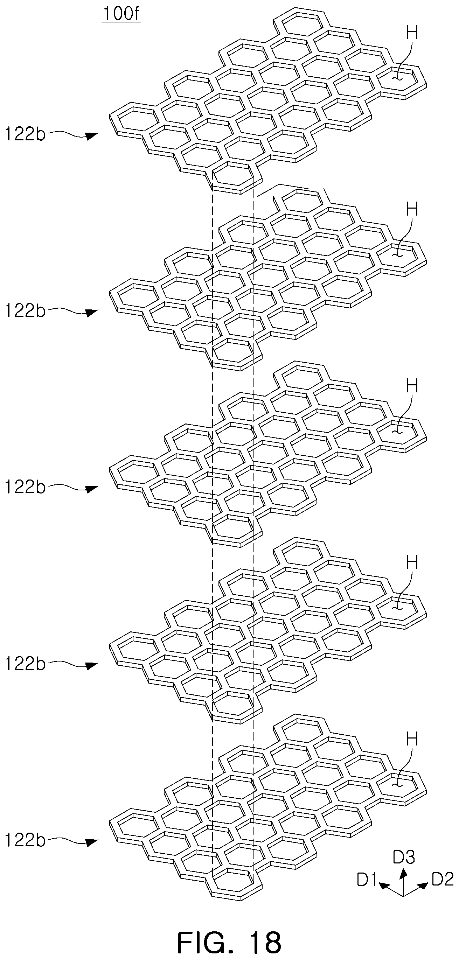

FIG. 18 is a perspective diagram illustrating an arrangement of guard-ring pattern layers of a semiconductor device 100f in a vertical direction according to an example embodiment.

Referring to FIGS. 17 and 18, the example embodiment may be the same as or similar to the example embodiment described with reference to FIGS. 1, 2, 3A, 3B, 4A, 4B, 5, 6, 7A, 7B, 8A, 8B, 9A, 9B, 10A, 10B, 11, 12, 13, 14A, 14B, 15, and 16. The example embodiment illustrated in FIGS. 17 and 18 may have a configuration in which each of the plurality of guard-ring pattern layers 122b of the guard-ring structure GS' of the semiconductor device 100f may have a mesh structure in which a plurality of through-holes H are repeated in at least one horizontal direction (e.g., D1 and/or D2).

The through-holes H of each of the plurality of guard-ring pattern layers 122b may be aligned to completely overlap in the vertical direction D3. For example, the plurality of guard-ring pattern layers 122b may have five layers that are stacked in the vertical direction D3. Each through-hole H in one of the guard-ring pattern layers 122b may be vertically aligned or overlap with corresponding one of the through-holes H in others of the guard-ring pattern layers 122b.

As each of the plurality of guard-ring pattern layers 122b of the guard-ring structure GS' includes the mesh structure, stress generated in the scribe lane region SLR during the dicing process may be suppressed from being transferred to the chip region CHR during the dicing process (see FIGS. 9A and 9B).

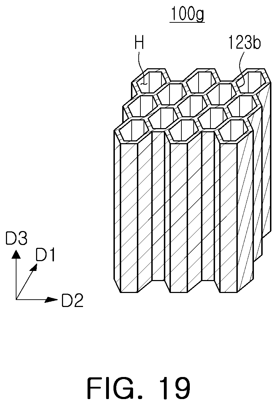

FIG. 19 is a perspective diagram illustrating an arrangement of guard-ring connection layers of a semiconductor device 100g in a vertical direction according to an example embodiment.

Referring to FIG. 19, the example embodiment may be the same as or similar to the example embodiment described with reference to FIGS. 1, 2, 3A, 3B, 4A, 4B, 5, 6, 7A, 7B, 8A, 8B, 9A, 9B, 10A, 10B, 11, 12, 13, 14A, 14B, 15, 16, 17, and 18. The example embodiment illustrated in FIG. 19 may have a configuration in which each of the plurality of guard-ring connection layers 123b of the guard-ring structure (GS' in FIG. 17) of the semiconductor device 100g may have a mesh structure in which a plurality of through-holes H are repeated in at least one horizontal direction (e.g., D1 and/or D2). For example, unlike the configuration described in FIG. 18, the guard-ring connection layers 123b shown in FIG. 19 may have a single continuous structure.

In the example embodiment, in view of the shape, the mesh structure of each of the plurality of guard-ring pattern layers 122b may be configured substantially the same as or similar to the mesh structure described with reference to FIG. 14A.

As each of the plurality of guard-ring connection layers 123b of the guard-ring structure (GS' in FIG. 17) includes the mesh structure, the influence of stress generated in the scribe lane region SLR by the dicing process may be suppressed from being transferred to the chip region CHR (see FIGS. 9A and 9B).

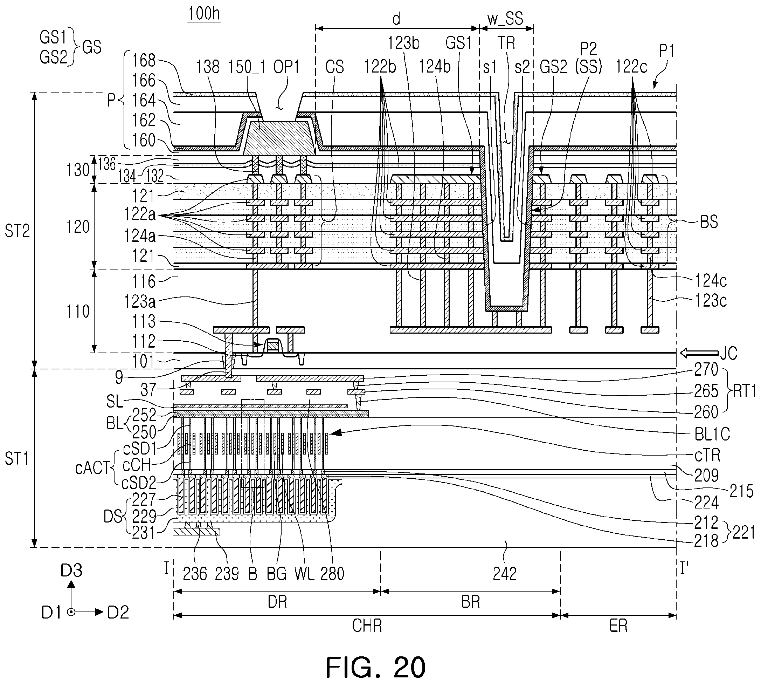

FIG. 20 is a vertical cross-sectional diagram illustrating a semiconductor device 100h according to an example embodiment.

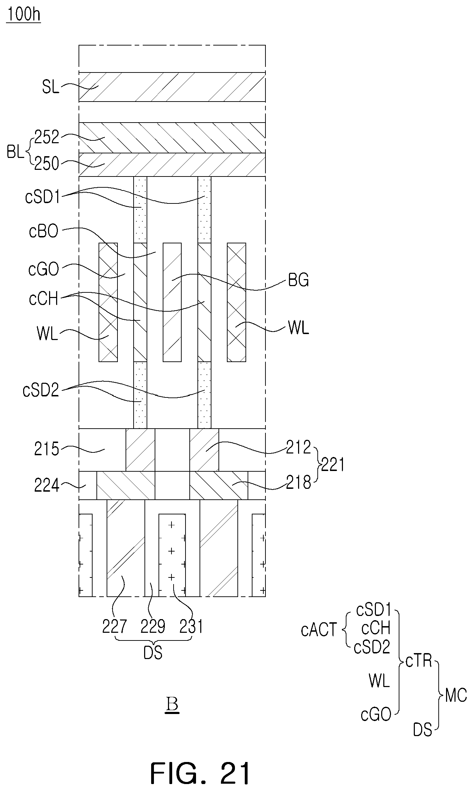

FIG. 21 is an enlarged diagram illustrating region 'B' illustrated in FIG. 20.

Referring to FIGS. 20 and 21, the example embodiment may be the same as or similar to the example embodiment described with reference to FIGS. 1 to 19, other than the configuration in which the semiconductor device 100h includes a first structure ST1 and a second structure ST2 vertically overlapping the first structure ST1.

The second structure ST2 may be disposed on the first structure ST1. In an example embodiment, the first structure ST1 may be a first chip structure including memory cells MC, and the second structure ST2 may be a second chip structure including a peripheral circuit for operating the memory cells. The first structure ST1 and the second structure ST2 may be bonded to each other by a bonding process, such as a wafer bonding process. Accordingly, the first structure ST1 may be in contact with and bonded to the second structure ST2.

Each of the memory cells may include a cell transistor (cTR) and a data storage structure which may function as data storage. In a memory such as DRAM, the data storage structure may be a cell capacitor for storing data.

The second structure ST2 may be configured substantially the same as or similar to the semiconductor device 100-100g described with reference to FIGS. 1, 2, 3A, 3B, 4A, 4B, 5, 6, 7A, 7B, 8A, 8B, 9A, 9B, 10A, 10B, 11, 12, 13, 14A, 14B, 15, 16, 17, 18, and 19. Accordingly, descriptions of overlapping elements may not be provided.

In the example embodiment, the integrated circuit element 113 may be referred to as a peripheral transistor. In the example embodiment, the interconnection structure CS may be referred to as a peripheral interconnection structure.

The second structure ST2 may further include a through-insulating pattern 9 formed in the semiconductor substrate 101. The through-insulating pattern 9 may have lower surfaces coplanar with a lower surface of the semiconductor substrate 101, and upper surfaces coplanar with an upper surface of the isolation region 102. The through-insulating patterns 9 may include at least one of low-κ dielectric, silicon oxide, silicon nitride, SiBN, SiCN, SiON, SiOCN, impurity-doped silicon oxide, or impurity-doped silicon nitride.

The first structure ST1 may include a wordline WL and a data storage structure DS disposed at a level lower than a level of the wordline WL. The wordline WL and the data storage structure DS may be disposed on the device region DR.

The data storage structure DS may include first electrodes 227 extending in the vertical direction, second electrodes 231 covering a side surface and a lower surface of each of the first electrodes 227, and a dielectric layer 229 between the first electrodes 227 and the second electrode 231.

The data storage structure DS may be configured as cell capacitors for storing data in a memory such as DRAM, but an example embodiment thereof is not limited thereto. For example, the data storage structure DS may be configured as a data storage structure of MRAM or a data storage structure of FeRAM.

The first structure ST1 may further include cell active patterns cACT.

Each of the cell active patterns cACT may include a first source/drain region cSD1, a second source/drain region cSD2 disposed at a level different from a level of the first source/drain region cSD1, and a vertical channel region cCH between the first and second source/drain regions cSD1 and cSD2. The first source/drain region cSD1 may be disposed at a level higher than a level of the second source/drain region cSD2. The cell active patterns cACT may also be referred to as a cell semiconductor layer or a vertical channel layer.

The first source/drain region cSD1, the second source/drain region cSD2, the vertical channel region cCH, the wordline WL facing the side surface of the vertical channel region CHc, and the gate dielectric layer cGO between the cell active pattern cACT and the wordline WL may be included in a cell transistor cTR. In an example embodiment, the cell transistor cTR may be referred to as a vertical channel transistor. In the wordline WL, a portion facing the vertical channel region cCH may be a gate electrode. The gate dielectric layer cGO may be in contact with a side surface of the vertical channel region cCH of the cell active pattern cACT, and the gate electrode portion of the wordline WL may be in contact with the gate dielectric layer cGO.

The back gate line BG may face a side surface of the vertical channel region CHc. A back gate dielectric layer cBO may be disposed between the back gate line BG and the vertical channel region cCH. The vertical channel region cCH may be disposed between the back gate line BG and the wordline WL. A pair of cell active patterns cACT adjacent to each other may be disposed between a pair of wordlines WL adjacent to each other, and the back gate line BG may be disposed between a pair of cell active patterns cACT adjacent to each other. The back gate line BG may be a back gate electrode.

The back gate line BG may control charges accumulated in the vertical channel region cCH. The vertical channel region cCH may be a floating body disposed between the first and second source/drain regions cSD1 and cSD2, and the back gate line BG may suppress or prevent degradation of performance of the cell transistor cTR due to the floating body effect and may improve performance of the cell transistor cTR. For example, the back gate line BG may reduce or prevent changes in threshold voltage of the cell transistor cTR caused by charges, such as holes accumulating in the floating body of the vertical channel region CHc during the operation of the cell transistor cTR.

The wordlines WL may be formed of doped polysilicon, Al, Cu, Ti, Ta, Ru, W, Mo, Pt, Ni, Co, TiN, TaN, WN, NbN, TiAl, TiAlN, TiSi, TiSiN, TaSi, TaSiN, RuTiN, NiSi, CoSi, or a combination thereof, but an example embodiment thereof is not limited thereto. Each of the wordlines WL may include a single layer or multiple layers of the aforementioned conductive materials. The back gate lines BG may include at least one conductive material. For example, each of the back gate lines BG may be formed of doped polysilicon, Al, Cu, Ti, Ta, Ru, W, Mo, Pt, Ni, Co, TiN, TaN, WN, NbN, TiAl, TiAlN, TiSi, TiSiN, TaSi, TaSiN, RuTiN, NiSi, CoSi, or a combination thereof, but an example embodiment thereof is not limited thereto. Each of the back gate lines BG may include a single layer or multiple layers of the aforementioned materials.

The first structure ST1 may further include contact structures 221 electrically connecting the second source/drain regions cSD2 to the first electrodes 227.

Each of the contact structures 221 may include a plug portion 212 in contact with the cell active pattern cACT and a pad portion 218 disposed below the plug portion 212. The data storage structures DS may be disposed below the pad portions 218.

The first structure ST1 may further include bitlines BL.

The bitlines BL may be connected to the cell active patterns cACT on the cell active patterns cACT. For example, the bitlines BL may be electrically connected to the first source/drain regions cSD1 of the cell active patterns cACT. Accordingly, the bitlines BL may be electrically connected to the cell transistors cTR.

Each of the bitlines BL may be formed of doped polysilicon, Al, Cu, Ti, Ta, Ru, W, Mo, Pt, Ni, Co, TiN, TaN, WN, NbN, TiAl, TiAlN, TiSi, TiSiN, TaSi, TaSiN, RuTiN, NiSi, CoSi, or a combination thereof, but an example embodiment thereof is not limited thereto. Each of the bitlines BL may include a single layer or multiple layers of the aforementioned conductive materials. For example, each of the bitlines BL may include a first conductive layer 250 and a second conductive layer 252 on the first conductive layer 250. The first conductive layer 250 may include doped silicon, and the second conductive layer 252 may include a conductive material having a lower resistivity than that of the doped silicon among the aforementioned conductive materials.

The first structure ST1 may further include a shield conductive structure SL disposed on an upper portion of the bitlines BL. The shield conductive structure SL may include a portion having a plate shape. The shield conductive structure SL may be spaced apart from the bitlines BL. The shield conductive structure SL may screen capacitive coupling between the bitlines BL. For example, the shield conductive structure SL may reduce the resistive-capacitive delay (RC delay) of the bitlines BL by reducing or blocking parasitic capacitance between the bitlines BL.

The first structure ST1 may further include a routing lower structure RT1. The routing lower structure RT may include first horizontal portions 260, vertical vias 265 on the first horizontal portions 260, and second horizontal portions 270 on the vertical vias 265. The first and second horizontal portions 260 and 270 may be redistribution layers for routing, and the vertical vias 265 may be conductive vias.

The first structure ST1 may further include bitline contacts BL1C electrically connecting the routing lower structure RT1 to the bitlines BL.

The first structure ST1 may further include capacitor vias 236 below the second electrodes 231 and capacitor interconnection 239 disposed below the capacitor vias 236 and extending upward or to an external side of the data storage structure DS.

The first structure ST1 may further include a first insulating structure 242, a second insulating layer 224 on the first insulating structure 242, a third insulating layer 215 on the second insulating layer 224, a fourth insulating structure 209 on the third insulating layer 215, and a fifth insulating structure 280 on the fourth insulating structure 209.

The data storage structures DS may be disposed in the first insulating structure 242. The second insulating layer 224 may be disposed on side surfaces of the pad portions 218. The third insulating layer 215 may be disposed on side surfaces of the plug portions 212. The cell transistors cTR and the back gate line BG may be disposed in the fourth insulating structure 209. The bitlines BL, the shield conductive structure SL, the bitline contacts BL1C, and the routing lower structure RT1 may be disposed in the fifth insulating structure 280.

The first and second structures ST1 and ST2 may further include a through-via 37 penetrating the through-insulating pattern 9. The through-via 37 may penetrate the through-insulating pattern 9, may extend upwardly and may be connected to the internal interconnection pattern 114 (or a peripheral interconnection structure), and may penetrate the through-insulating pattern 9, may extend downwardly and may be connected to the routing lower structure RT1.

The through-via 37 may be formed of doped polysilicon, Al, Cu, Ti, Ta, Ru, W, Mo, Pt, Ni, Co, TiN, TaN, WN, NbN, TiAl, TiAlN, TiSi, TiSiN, TaSi, TaSiN, RuTiN, NiSi, CoSi or a combination thereof, but an example embodiment thereof is not limited thereto. The through-via 37 may include a single layer or multiple layers of the aforementioned conductive materials. For example, the through-via 37 may include a conductive pillar and a conductive barrier layer covering a side surface and a lower surface of the conductive pillar.

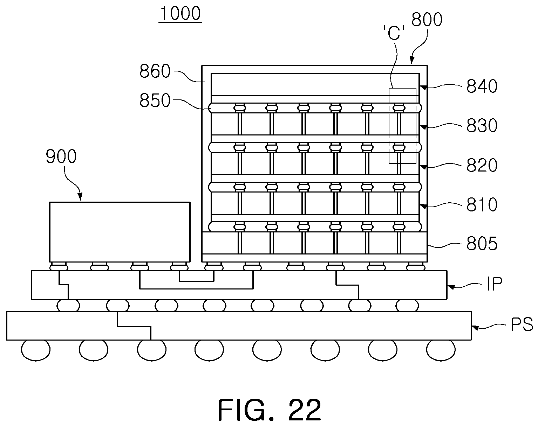

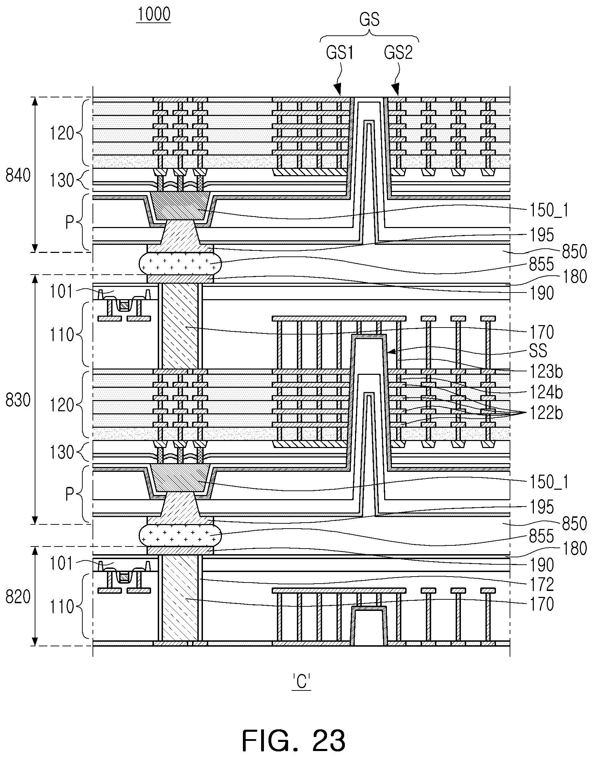

FIG. 22 is a cross-sectional diagram illustrating a semiconductor package including any one of the semiconductor devices 100-100h according to an example embodiment. FIG. 23 is an enlarged diagram illustrating region 'C' illustrated in FIG. 22.

Referring to FIGS. 22 and 23, the semiconductor package 1000 in the example embodiment may be configured as a high bandwidth memory (HBM) package. The semiconductor package 1000 may include a package substrate PS, an interposer IP mounted on the package substrate PS, a memory package 800 mounted on the interposer IP, and a processor chip 900. The interposer IP may electrically connect the memory package 800 to the processor chip 900.

The memory package 800 may include a buffer chip 805, a first semiconductor device 810, a second semiconductor device 820, a third semiconductor device 830, and a fourth semiconductor device 840, stacked in order. The buffer chip 805 and the first to fourth semiconductor devices 810, 820, 830, and 840 may have a structure the same as or similar to that of any one of the semiconductor devices 100-100h described with reference to FIGS. 10A, 10B, 11, 12, 13, 14A, 14B, 15, 16, 17, 18, 19, 20, and 21 and may include elements corresponding to, for example, an isolation structure SS formed on the buffer region BR, and second dummy connection layers 123d_2 formed on the edge region ER and having various repetitive patterns. Also, the second to fourth semiconductor devices 820, 830, and 840 may include elements corresponding to a through-electrode 170, a via insulating layer 172, a lower passivation layer 180, and a via pad 190.

In an example embodiment, the buffer chip 805 may be a different type of semiconductor chip from the first to fourth semiconductor devices 810, 820, 830, and 840. For example, the buffer chip 805 may be a logic chip, and the first to fourth semiconductor devices 810, 820, 830, and 840 may be memory chips. The logic chip may include a microprocessor, an analog device, or a digital signal processor. The memory chip may include a volatile memory chip, such as a dynamic random access memory (DRAM) or static random access memory (SRAM), or a non-volatile memory chip, such as phase-change random access memory (PRAM), magnetoresistive random access memory (MRAM), ferroelectric random access memory (FeRAM), or resistive random access memory (RRAM).

The memory package 800 may further include an adhesive layer 850 and an encapsulant 860. The adhesive layer 850 may be disposed between the buffer chip 805 and the first semiconductor device 810, and between the first to fourth semiconductor devices 810, 820, 830, and 840. The adhesive layer 850 may be a non-conductive film (NCF) or a non-conductive paste (NCP). The encapsulant 860 may be a resin including epoxy or polyimide. For example, the resin may include a bisphenol-group epoxy resin, a polycyclic aromatic epoxy resin, an o-cresol novolac epoxy resin, a biphenyl-group epoxy resin, or a naphthalene-group epoxy resin.

The processor chip 900 may be a central processing unit (CPU), a graphics processing unit (GPU), a mobile application, or a digital signal processor (DSP) chip.

The memory package 800 may further include a bump 855 between the second semiconductor device 820 and the third semiconductor device 830 and between the third semiconductor device 830 and the fourth semiconductor device 840. The first to fourth semiconductor devices 810, 820, 830, and 840 may further include a connection pad 195 connected to the first pad structure 150_1. The connection pad 195 may fill the first opening OP1 illustrated in FIG. 10A and may be in contact with the first pad structure 150_1. The bump 855 may connect the via pad 190 to the connection pad 195 between adjacent semiconductor devices 820, 830, and 840. An adhesive layer 850 may cover side surfaces of the via pad 190, the connection pad 195 and the bump 855. In an example embodiment, the bump 855 may not be provided, and the via pad 190 and the connection pad 195 may be in contact with each other.

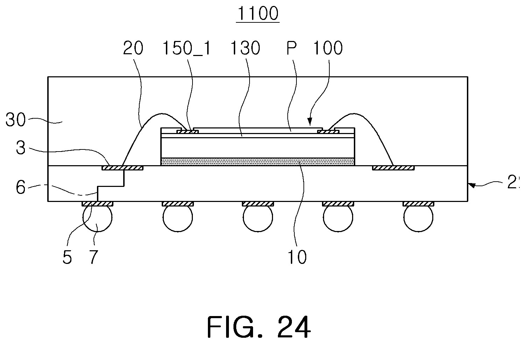

FIG. 24 is a cross-sectional diagram illustrating a semiconductor package including any one of the semiconductor devices 100-100h according to an example embodiment.

Referring to FIG. 24, a semiconductor package 1100 may include a substrate 2, an adhesive member 10, a bonding wire 20, and an encapsulant 30. The semiconductor package 1100 may further include a semiconductor device 100 on the substrate 2. The semiconductor package 1100 may include any one of the semiconductor devices 100a-100h described with reference to FIGS. 12, 13, 14A, 14B, 15, 16, 17, 18, 19, and 20.

The substrate 2 may include upper pads 3, lower pads 5, internal interconnections 6, and external connection terminals 7. In an example embodiment, the substrate 2 may be implemented as a printed circuit board and may include an insulating material such as phenolic resin, epoxy resin, or prepreg. In another example embodiment, the substrate 2 may be a redistribution structure in which an insulating material and a conductive material are stacked. The upper pads 3 and the lower pads 5 may be formed by forming a metal layer on the base of the substrate 2 and patterning the metal layer.

The upper pads 3 may be disposed on an upper surface of the substrate 2 and may be electrically connected to the semiconductor device 100. The lower pads 5 may be disposed on a lower surface of the substrate 2, and the upper pads 3 may be electrically connected to the corresponding lower pads 5 by the internal interconnections 6. The external connection terminals 7 may be disposed on a lower portion of the lower pads 5. The lower pad 5, the upper pad 3, and the internal interconnections 6 may include a metal such as copper (Cu). The external connection terminal 7 may be a solder bump 855.

The semiconductor device 100 may include an insulating structure 130, a first pad structure 150_1, and a passivation structure P, which may be the same or similar to the elements of the semiconductor device 100 illustrated in FIG. 10A. The insulating structure 130 may be disposed on an upper portion of the semiconductor device 100. The passivation structure P may be disposed on the insulating structure 130 and may protect the insulating structure 130 from external physical impact. At least a portion of the first pad structure 150_1 may be buried in the passivation structure P. The first pad structure 150_1 may be connected to the upper pad 3 by a bonding wire 20.

An adhesive member 10 may be disposed between the substrate 2 and the semiconductor device 100. The adhesive member 10 may fix the semiconductor device 100 to the substrate 2. The adhesive member 10 may be a die attach film (DAF), but an example embodiment thereof is not limited thereto. The encapsulant 30 may cover the substrate 2, the semiconductor device 100, and the bonding wire 20.

According to the aforementioned example embodiments, a semiconductor device having improved reliability and performance and a semiconductor package including the same may be provided. Also, a method of manufacturing a semiconductor device may be provided.

Also, a semiconductor device including dummy connection layers disposed on a lower portion of a test pattern on an edge region, extending in at least one direction and having a repetitive pattern may be provided.

Also, a semiconductor device including an isolation structure penetrating a guard-ring structure on a buffer region may be provided.

According to an example embodiment of the present disclosure, a method of manufacturing a semiconductor device includes forming a substrate including a device region, a buffer region surrounding the device region, and a scribe lane region surrounding the buffer region; forming a device layer on the substrate, where the device layer includes a plurality of guard-ring connection layers formed on the buffer region to surround the device region, at least one dummy connection layer on the scribe lane region, and an insulating layer burying the guard-ring connection layers and the at least one dummy connection layer, and the at least one dummy connection layer includes a pattern extending and repeating in the first direction D1; forming an interconnection layer including a plurality of structures on the device layer, where the plurality of structures include an interconnection structure including a plurality of interconnection pattern layers stacked in the vertical direction D3 on the device region, a guard-ring structure including a plurality of guard-ring pattern layers stacked in the vertical direction D3 on the plurality of guard-ring connection layers on the buffer region, and a dummy structure including a plurality of dummy pattern layers stacked in the vertical direction D3 on the at least one dummy connection layer on the scribe lane region; forming pad structures on the interconnection layer, where the pad structures include a first pad structure disposed on the interconnection structure and electrically connected to the plurality of interconnection pattern layers, and a second pad structure including a first pad portion disposed on the device region and spaced apart from the first pad structure, an extension portion extending from the first pad portion to the buffer region, and a second pad portion extending from the extension portion to the scribe lane region and electrically connected to the plurality of dummy pattern layers of the dummy structure; and forming a trench penetrating the plurality of guard-ring pattern layers of the guard-ring structure on the buffer region.

The at least one dummy connection layer of the dummy structure may include a plurality of dummy connection layers, and each of the plurality of dummy connection layers may have a line structure having a first width in the first direction D1, which is greater than a second width in the second direction D2 perpendicular to the first direction D1, and having a thickness in the vertical direction D3.

At least one dummy connection layer of the dummy structure may have a plate-shaped structure having a thickness in the vertical direction D3.

The at least one dummy connection layer of the dummy structure may include a plurality of dummy connection layers, and each of the plurality of dummy connection layers may have a mesh structure in which a plurality of through-holes are repeated in the first direction D1 and the second direction D2 perpendicular to the first direction D1.

A horizontal cross-section through each through-hole of the plurality of through-holes may have a circular or polygonal shape.

The trench may be disposed parallel to the second pad portion of the second pad structure such that the portion of the trench and the second pad portion of the second pad structure extend in the first direction D1.

A distance between the interconnection structure and the trench may be in a range of 3 µm to 5 µm.

The method may further include forming a passivation layer disposed on the interconnection layer and at least a portion of which fills the trench.

The method may further include forming an opening penetrating the passivation layer and exposing the first pad structure and the first pad portion of the second pad structure.

The method may further include a dicing process of dicing the substrate in the vertical direction along the scribe lane region.

While the example embodiments have been illustrated and described above, it will be understood as apparent to those skilled in the art that modifications and variations could be made without departing from the scope of the present disclosure.

## Claims

1. A semiconductor device (100), comprising:
a lower structure; and
an upper structure on the lower structure,
wherein the lower structure includes:
a substrate (101) including a device region (DR), a buffer region (BR) surrounding the device region (DR), and an edge region (ER) surrounding the buffer region (BR);
an interconnection structure (CS) including a plurality of interconnection pattern layers (122a) stacked in a vertical direction (D3) on the device region (DR);
a guard-ring structure (GS) including a plurality of guard-ring pattern layers (122b) stacked in the vertical direction (D3) on the buffer region (BR) to surround the device region (DR); and
a dummy structure (DS) including a plurality of dummy pattern layers (122d, 122u) stacked in the vertical direction (D3) on the edge region (ER), a plurality of dummy via layers (124d), and at least one dummy connection layer (123d) between the substrate (101) and a lowest dummy pattern layer (122d) among the plurality of dummy pattern layers (122d, 122u),
wherein the upper structure includes:
pad structures (150_1, 150_2) on the device region (DR); and
a passivation layer (P) on the pad structures (150_1, 150_2),
wherein the pad structures (150_1, 150_2) include:
an active pad structure (150_1) disposed on the interconnection structure (CS) and electrically connected to the plurality of interconnection pattern layers (122a); and
a dummy pad structure (150_2) including a first dummy pad portion (150p) spaced apart from the active pad structure (150_1) and extending along the buffer region (BR) and the edge region (ER) from the first dummy pad portion (150p), where an end of the dummy pad structure (150_2) is disposed on the dummy structure (DS),
wherein the at least one dummy connection layer (123d) of the dummy structure (DS) extends in a first direction (D1) and has a repeating pattern,
wherein the passivation layer (P) includes:
a first portion (P1) including openings respectively exposing the active pad structure (150_1) and the first dummy pad portion (150p) of the dummy pad structure (150_2) on the device region (DR), and the first portion (P1) extending from the device region (DR) to the buffer region (BR) and the edge region (ER); and
a second portion (P2) disposed on the buffer region (BR), extending downwardly from the first portion (P1), and penetrating at least a portion of the plurality of guard-ring pattern layers (122b) of the guard-ring structure (GS).

2. The semiconductor device (100) of claim 1,
wherein the at least one dummy connection layer (123d) of the dummy structure (DS) includes a plurality of dummy connection layers (123d_2), and
wherein each dummy connection layer (123d_2) of the plurality of dummy connection layers (123d_2) has a line structure (LS) having a first width in the first direction (D1), which is greater than a second width in a second direction (D2) perpendicular to the first direction (D1), and having a thickness in the vertical direction (D3).

3. The semiconductor device (100) of claim 1, wherein the at least one dummy connection layer (123d) of the dummy structure (DS) has a plate shape extending along the first direction (D1) and a second direction (D2) perpendicular to the first direction (D1).

4. The semiconductor device (100) of claim 1,
wherein the at least one dummy connection layer (123d) of the dummy structure (DS) includes a plurality of dummy connection layers (123d_2), and
wherein each of the plurality of dummy connection layers (123d_2) has a mesh shape in which a plurality of through-holes (H) are repeated in the first direction (D1) and a second direction (D2) perpendicular to the first direction (D1).

5. The semiconductor device (100) of claim 4, wherein each of the plurality of through-holes (H) has a circular or polygonal shape.

6. The semiconductor device (100) of any preceding claim, wherein the dummy pad structure (150_2) further includes:
an extension portion (150e) extending from the first dummy pad portion (150p) to the buffer region (BR); and
a second dummy pad portion (150d) extending from the extension portion (150e) to the edge region (ER),
wherein the first dummy pad portion (150p), the extension portion (150e) and the second dummy pad portion (150d) constitute a single continuous body.

7. The semiconductor device (100) of claim 6, wherein the second dummy pad portion (150d) of the dummy pad structure (150_2) and an uppermost dummy pattern layer (122u) of the plurality of dummy pattern layers (122d, 122u) of the dummy structure (DS) are in contact with each other.

8. The semiconductor device (100) of claim 7, wherein a width of the uppermost dummy pattern layer (122u) increases toward the second dummy pad portion (150d).

9. The semiconductor device (100) of any one of claims 6 to 8, wherein the second portion (P2) of the passivation layer (P) is adjacent to the extension portion (150e) of the dummy pad structure (150_2).

10. The semiconductor device (100) of any one of claims 6 to 9, wherein at least a portion of the second portion (P2) of the passivation layer (P) is disposed in parallel with the second dummy pad portion (150d) of the dummy pad structure (150_2) in a second direction (D2) perpendicular to the first direction (D1).

11. The semiconductor device (100) of any preceding claim, wherein a distance (d) between the interconnection structure (CS) and the second portion (P2) of the passivation layer (P) is in a range of 3 µm to 5 µm.

12. The semiconductor device (100) of any preceding claim,
wherein the second portion (P2) of the passivation layer (P) includes:
a first side adjacent to the interconnection structure (CS); and
a second side opposite the first side,
wherein the guard-ring structure (GS) has a first portion (GS1) disposed on the first side and having a first width in the second direction (D2) and a second portion (GS2) disposed on the second side and having a second width in the second direction (D2) which is different from the first width in the second direction (D2).

13. The semiconductor device (100) of claim 12, wherein the first width in the second direction (D2) of the first portion (GS1) of the guard-ring structure (GS) is greater than the second width in the second direction (D2) of the second portion (GS2) of the guard-ring structure (GS).

14. The semiconductor device (100) of any preceding claim, wherein a lower surface of the second portion (P2) of the passivation layer (P) is at a lower level than a lower surface of a lowest guard-ring pattern layer (122b) among the plurality of guard-ring pattern layers (122b).

15. The semiconductor device (100) of any preceding claim, wherein the lower structure further comprises a device layer (110) disposed on the semiconductor substrate (101) and including an integrated circuit element (113) and a data storage structure (CAP) on the device region (DR).
